# EUROPEAN PATENT SPECIFICATION

(11) **EP 1 730 773 B1**
(45) Date of publication and mention of the grant of the patent: **24.09.2008**
(21) Application number: 05713281.3
(22) Date of filing: 11.02.2005
(51) Int. Cl.: H01L 21/768, G03F 7/075, C08F 232/00

(54) **POLYMERS OF POLYCYCLIC OLEFINS HAVING A POLYHEDRAL OLIGOSILSESQUIOXANE PENDANT GROUP AND USES THEREOF**
POLYMERE POLYZYKLISCHER OLEFINE MIT POLYEDRISCHEN OLIGOSILSESQUIOXAN SEITENGRUPPE UND DEREN EINSATZ
POLYMERES D'OLEFINES POLYCYCLIQUES COMPORTANT UN GROUPE LATERAL OLIGOSILSESQUIOXANE POLYEDRIQUE, ET LEURS UTILISATIONS

(30) Priority: 13.02.2004 US 544623 P; 10.02.2005 US 54963
(43) Date of publication of application: 13.12.2006
(73) Proprietor: Promerus, LLC, Brecksville, OH 44141 (US)
(72) Inventor: RHODES, Larry, F., Silver Lake, Ohio 44224 (US); SEGER, Larry, Gates Mills, Ohio 44040 (US); RAVIKIRAN, Ramakrishna, Vernon Hills, Illinois 60061 (US); ELCE, Edmund, Lakewood, Ohio 44107 (US); SHICK, Robert, Strongsville, Ohio 44149 (US); LIPIAN, John-Henry, Medina, Ohio 44256 (US)
(74) Representative: von Kreisler, Alek
(86) International application number: PCT/US2005/004239
(87) International publication number: WO 2005/081306

(56) References cited:
- WO-A-99/42502
- WO-A-03/050158
- WO-A-20/04040371
- MATHER P.T., JEON H.G., ROMO-URIBE A., HADDAD T.S., LICHTENHAN J.D.: "Mechanical Relaxation and Microstructure of Poly(norbornyl-POSS) Copolymers" MACROMOLECULES, vol. 32, 1999, pages 1194-1203, XP002328683

## Description

The present invention generally relates to polymers encompassing norbornene-type repeating units having silsesquioxane-type pendant groups, and more specifically to such polymers that have polyhedral oligosilsesquioxane pendant groups and the uses thereof for the manufacturing of microelectronic devices.

### BACKGROUND

Inorganic materials such as silicon dioxide, silicon oxynitride and silicon nitride have been traditionally employed in the microelectronics industry for a variety of uses including, but not limited to, insulation layers and structures, passivation layers and layers used as hard masks for photolithography and etch. For example, silicon dioxide, having a dielectric constant of about 3.9, is widely employed as an insulation layer in the manufacture of microelectronic devices such as integrated circuit (IC) devices. However, as IC's have been scaled down in size to allow for more, smaller devices, the total interconnect capacitance of such IC's has increased. Exemplary of this increase is the increase in the line to line capacitance that has been the result of decreases in spacing between adjacent conductive lines. In some high speed circuits, this interconnect capacitance can be the limiting factor in the speed at which the IC can function. One way of limiting this increase in capacitance is to use a low dielectric constant material as insulation between the conductors, rather than silicon dioxide. To this effect, a variety of organic based materials have been investigated as potential low dielectric constant materials.

However, many such alternative materials have been found problematic due to less than desirable "other material characteristics." For example high moisture uptake, inadequate adhesion to the underlying substrate, poor or marginal chemical resistance, low glass transition temperatures (e.g., T_{g}<250°C), inadequate toughness and poor or marginal thermo and thermo-oxidative stabilities. Therefore it would be advantageous to provide a material having both a low dielectric constant (low-K) and more desirable "other characteristics." In addition, it would be advantageous to provide such a material that also can be utilized as a sacrificial material. That is to say, a material that has the aforementioned desirable "other characteristics" but which can also be readily removed to leave an "air gap" in a dielectric structure and thus provide a very low-K structure.

US Patent No. 5,912,313 by McIntosh III; et. al., was issued June 15, 1999 and entitled *"Addition polymers of polycycloolefins containing silyl functional groups."* The '313 patent discloses polycycloolefin materials containing silyl functional groups that are useful for forming dielectric coatings and films in the construction and manufacture of multichip modules (MCMs) and integrated circuits (ICs), in electronic packaging, in flexible film substrates, and due to the transparency of such materials, in optical applications such as in flat panel displays and the like.

US Patent No. 6,121,340 by Shick, et. al., was issued September 19, 2000 and entitled *"Photodefinable dielectric compositions comprising polycyclic polymers."* The '340 patent discloses photodefinable dielectric compositions comprising a photoinitiator and a polycyclic addition polymer, where the polymer comprises polycyclic repeating units that contain pendant silyl functionalities containing hydrolysable substituents. Advantageously, upon exposure to a radiation source the photoinitiator catalyzes the hydrolysis of the hydrolysable groups to affect the cure of the polymer and adhesion of the polymer to desired substrates.

While both the '313 and '340 patents advanced the technology to which they were directed, additional advances are still needed. Therefore it would be advantageous to provide improved organic based materials that can be employed as low-K materials. Additionally, for some applications, it would be advantageous to provide such low-K materials that are additionally directly photoimageable. That is to say, that the material once applied as a layer over a substrate is patternable without the need for any additional layer such as a photoresist. It would also be desirable, for some applications, to provide such improved organic based materials that are useful in photolithographic processing where such materials have enhanced etch selectivity and are hence useful for multilayer photoresist formulations.

U.S. Patent No. 6,610,593 by Kohl et. al., was issued August 26, 2003 and entitled *"Fabrication of semiconductor device with air gaps for ultra low capacitance interconnections and methods of making same."* The '593 patent discloses methods of forming air gaps or gaps within semiconductor structures by causing the decomposition of a sacrificial material into one or more gaseous decomposition products which are removed, in one embodiment by diffusion, through an overcoat layer.

While the '593 patent advanced the technology to which it was directed, additional advances are still needed. Therefore it would be advantageous to provide improved sacrificial materials that are more compatible with present and future semiconductor fabrication methods.

### BRIEF DESCRIPTION OF THE DRAWINGS

Embodiments of the invention are described below with reference to the following accompanying drawings.

FIGS. 1a-1d are simplified cross-sectional representations of a portion of a semiconductor structure illustrating several steps of a method for forming a low-K dielectric structure in accordance with an embodiment of the present invention;

FIGS. 2a-2d are simplified cross-sectional representations of a portion of a semiconductor structure, illustrating several steps of a method for forming an "air gap" structure in accordance with another embodiment of the present invention;

FIGS. 3a-3d are simplified cross-sectional representations of a portion of a semiconductor structure, illustrating an etch selective layer embodiment in accordance with the present invention.

### DETAILED DESCRIPTION

Embodiments in accordance with the present invention are described herein below. Such embodiments encompass compositions of norbornene-type polymers that include repeating units that encompass a polyhedral oligosilsesquioxane pendant group. Advantageously, these norbornene-type polymers are highly transparent (at 193 and 157 nm), have a low dielectric constant (as compared to silicon dioxide), have high resistance to plasma etching processes and have high glass transition temperatures (Tg) (as compared to analogous methacrylate polymers), and decompose into one or more gaseous decomposition products that can be removed to form a gap in a portion of a semiconductor device.

Unless otherwise indicated, all numbers, values and/or expressions referring to quantities of ingredients, reaction conditions, etc., used herein are to be understood as modified in all instances by the term "about."

Various numerical ranges are disclosed in this patent application. Because these ranges are continuous, they include every value between the minimum and maximum values of each range. Unless expressly indicated otherwise, the various numerical ranges specified in this specification and in the claims are approximations that are reflective of the various uncertainties of measurement encountered in obtaining such values.

As stated herein, the terms "polycycloolefin," "polycyclic," and "norbornene-type" are used interchangeably herein to mean a monomer material that contains at least one norbornene moiety in accordance with Structure 1 shown below, or a polymeric material that was formed from such a monomer and that has at least one repeat unit in accordance with Structure 2, also shown below:

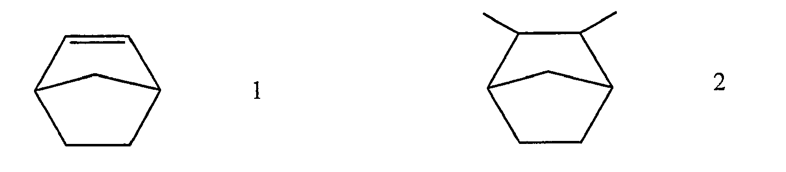

Some embodiments in accordance with the present invention are polymers that encompass two or more different types of repeat units derived from norbornene-type monomers, where at least one such type of repeat unit has a polyhedral oligosilsesquioxane pendant group. Such polyhedral oligosilsesquioxane containing repeat units are derived from norbornene-type monomers represented by Formula A, below. 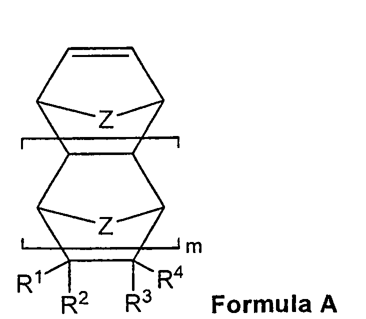 where m is an integer from 0 to about 5; Z represents -(CH₂)ₚ, -O-, -S-, or -NH-, and p is either 1 or 2. Further, at least one of R¹, R², R³, or R⁴, independently, is a polyhedral oligosilsesquioxane moiety and each of the remaining R¹, R², R³, or R⁴ groups, independently, is a hydrogen atom, or a linear or branched hydrocarbyl group having from 1 to about 20 carbon atoms. Monomers in accordance with Formula A are available from Hybrid Plastics of Hattiesburg, MS, and include, but are not limited to, Formulae A1, A2, A3, A4, A5 and A6, below: 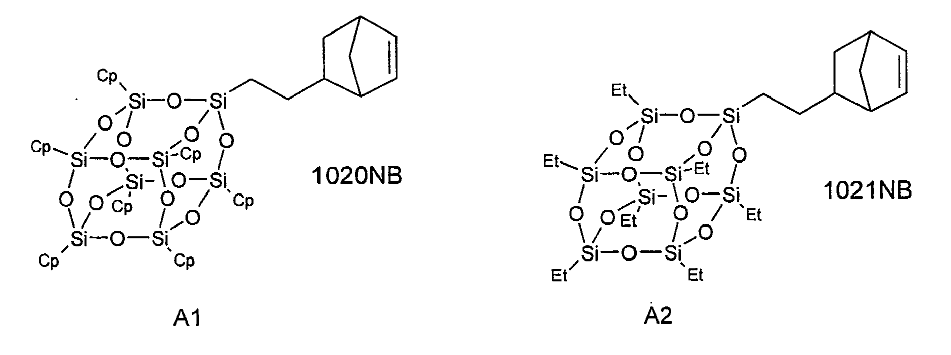 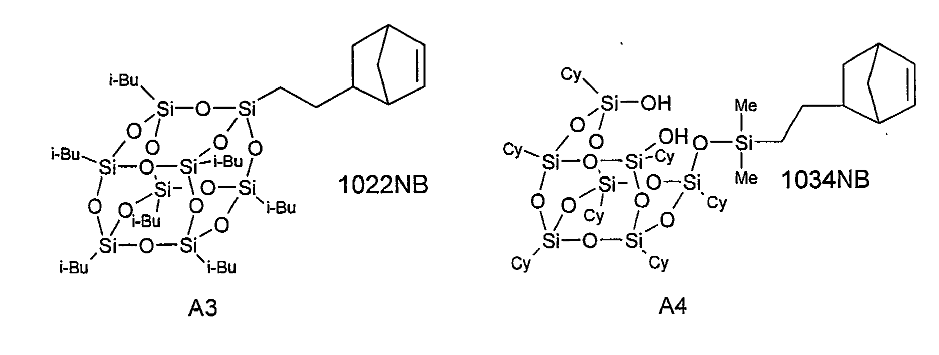 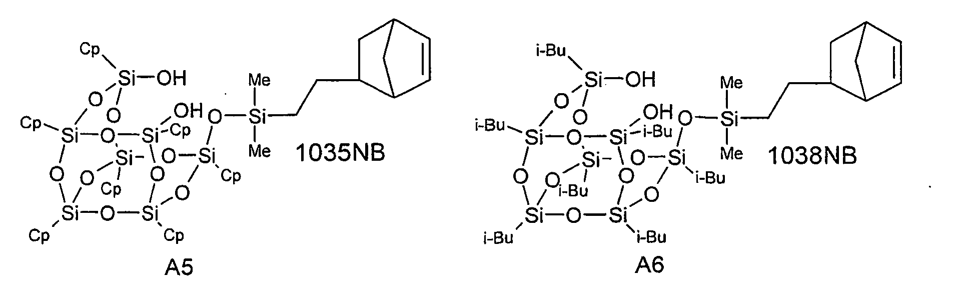 where Cp is cyclopentyl, Cy is cyclohexyl, Me is methyl, Et is ethyl and i-Bu is iso butyl.

Some embodiments of the present invention include repeat units derived from norbornene-type monomers having an acid labile protected pendant group. Such monomers are represented by Formula B, below: 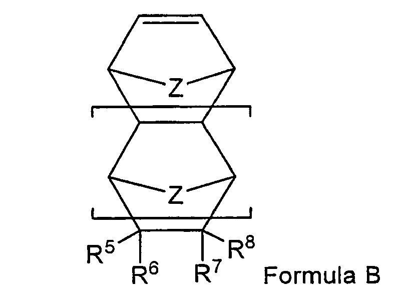 where m and Z are defined above and where at least one of R⁵, R⁶, R⁷, or R⁸, independently, is an acid labile protected pendant group that is cleavable by, for example, an acid generated from a photoacid generator. Any known acid labile group known to the literature and to the art can be utilized in the present invention such as those set forth herein with regard to Formula B.

The remaining one or more R⁵, R⁶, R⁷, or R⁸, groups, independently, can be hydrogen, or a hydrocarbyl having from 1 to about 20 carbon atoms, or halogens selected from F, Cl or Br, or a hydrocarbyl having from 1 to about 20 carbon atoms substituted at any hydrogen atom with an O, S, N, or Si, and the like, or a fluorinated hydrocarbyl having from 1 to about 20 carbon atoms wherein each carbon atom, independently, is substituted with 0, 1, 2, or 3 fluorine atoms.

In some embodiments, the acid labile group is a fluorinated carbinol moiety having from 1 to about 20 carbon atoms wherein each carbon atom, independently, is substituted with 0, 1, 2, or 3 fluorine atoms and the oxygen atom is protected by an acid labile group (i.e., blocking or protective groups) that are cleavable by acids generated from a photoacid generator. Any acid labile group known to the art and to the literature can be employed in the present invention. Advantageous fluorinated groups include, among others, -((CH₂)ₙO)_{n*}-CH₂-C(OR')(CF₃)₂ and -O-((CH₂)ₙO)_{n*}-CH₂-C(OR')(CF₃)₂ where n and n* are integers from 0 to about 10, and where R' is the acid labile group. R' includes, but is not limited to, -CH₂OCH₃ (dimethyl ether), -CH₂OCH₂CH₃ (methyl ethyl ether), -C(CH₃)₃, -Si(CH₃)₃, -CH₂C(O)O(t-Bu), isobornyl, 2-methyl-2-adamantyl, tetrahydrofuranyl, tetrahydropyranoyl, 3-oxocyclohexanonyl, mevalonic lactonyl, dicyclopropylmethyl (Dcpm), or dimethylcyclopropylmethyl (Dmcp) groups, or R' is -C(O)OR" where R" is -C(CH₃)₃, -Si(CH₃)₃, isobornyl, 2-methyl-2-adamantyl, tetrahydrofuranyl, tetrahydropyranoyl, 3-oxocyclohexanonyl, mevalonic lactonyl, Dcpm, or Dmcp groups, or combinations thereof.

In some embodiments of the present invention., Formula B is represented by Formula B1, below 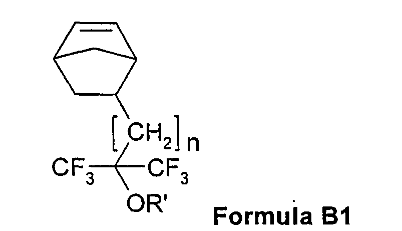 where n and R' are as previously defined.

More specifically, exemplary monomers encompassing an acid labile protected pendant group include:

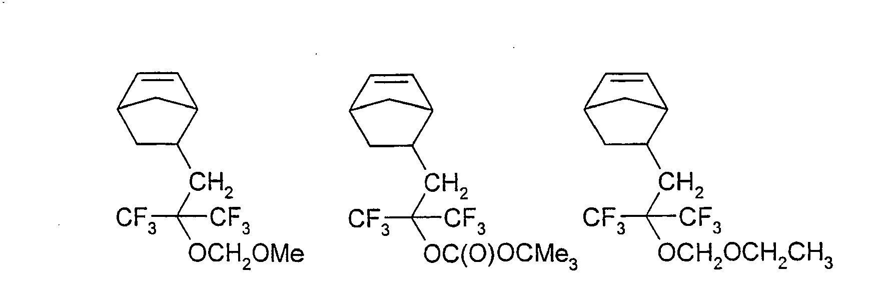

Other norbornene-type monomers in accordance with Formula B are represented by Formula B2, below: 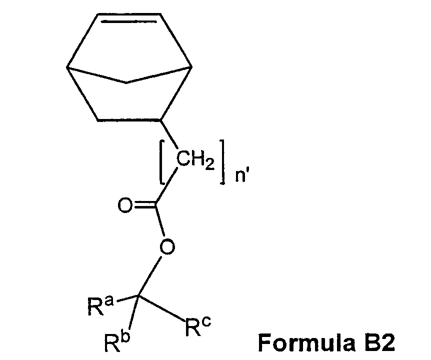 where n' is an integer 1 to about 5 and R^{a}, R^{b}, and R^{c}, independently, represent linear or branched hydrocarbyl groups from C₁ to about C₂₀ or where R^{a} and R^{b} taken together along with the common carbon to which they are attached can represent saturated C₄ to C₁₂ cyclic groups.

An exemplary norbornene-type monomer in accordance with Formula B2 encompasses: 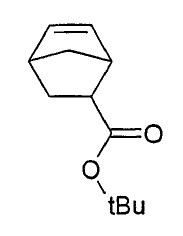 where tBu is a tertiary butyl group.

Some embodiments of the present invention include repeat units derived from norbornene-type monomers having a crosslinking capable pendant group. Such monomers are represented by Formula C, below: 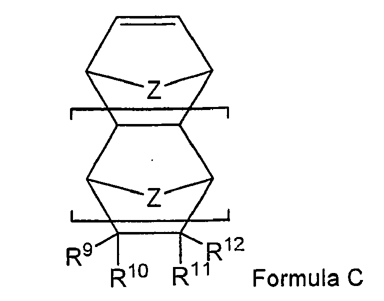 where m and Z are defined as above, and where each of R⁹, R¹⁰, R¹¹ and R¹², independently, are H, a halogen, a linear or branched C₁ to C₃₀ alkyl or C₄ to C₁₂ cycloalkyl, an alkylol, an aryl, an aralkyl, an alkaryl, an alkenyl or an alkynyl; with the proviso that at least one of R⁹, R¹⁰, R¹¹ and R¹² is a functional group that is capable of crosslinking. Suitable crosslinking capable functional groups include, but are not limited to, a hydroxy alkyl ether according to Formula C1:

-A-O-[-(CR**₂)_{q}-O-]ₚ- (CR**₂)_{q}-OH Formula C1

where A is a linking group selected from C₁ to C₆ linear or branched alkylene or, C₄ to C₆ cyclic alkylene, or -C(O)-, and each occurrence of R** is independently selected from H, methyl, ethyl and a halide, q is independently an integer from 1 to 5, in some cases from 2 to 5, and p is an integer from 0 to 3; a group according to Formula C2:

-R***-Q Formula C2

where R*** is a linear or branched C₁ to C₃₀, optionally partially or completely halogenated, alkylene, arylene, aralkylene, alkarylene, alkenylene, alkynylene or C₄ to C₁₂ cyclic alkylene linking group and Q is a functional group selected from a hydroxyl, a carboxylic acid, an amine, a thiol, an isocyanate, an epoxy and a gylcidyl ether; a group according to Formula C3:

-CᵣX"₂ᵣ₊₁ Formula C3

wherein X" is independently a halogen selected from fluorine, chlorine, bromine or iodine and r is an integer from 1 to 20; a group according to Formula C4:

-(CH₂)ₙC(O)OR^{#} Formula C4

where n is as defined above and R^{#} represents an acid labile group cleavable by a photoacid generator; and a group represented by Formula C5:

-(CH₂)ₜ-C(CF₃)₂-O-(CH₂)ₜ-CO-(OR^{##}) Formula C5

where each occurrence of t is independently an integer from 1 to 6 and R^{##} is a C₁-C₈ linear or branched alkyl, and in some instances a t-butyl group.

In addition, some embodiments in accordance with the present invention include repeat units derived from norbornene-type monomers having pendant groups that are exclusive of polyhedral oligosilsesquioxane groups, acid labile protected groups and crosslinking capable groups. Such monomers are represented by Formula D, below: 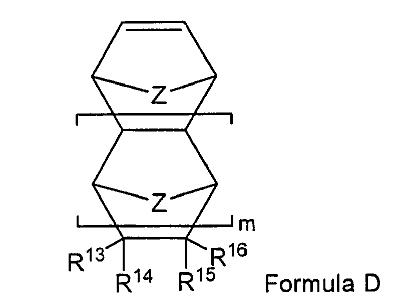 where m and Z are defined as above, and where substitutents R¹³, R¹⁴, R¹⁵ and R¹⁶, are each independently hydrogen, a linear or branched C₁ to C₁₀ alkyl or a neutral substituent selected from the group of substituents consisting of halogens selected from F, Cl or Br, -(CH₂)ₙ-C(O)OR¹⁷, -(CH₂)ₙ-OR¹⁸, -(CB₂)ₙ-OC(O)R¹⁷, -(CH₂)ₙ-OC(O)OR¹⁷, -(CH₂)ₙ-C(O)R¹⁸, -(CH₂)ₙC(R¹⁹)₂CH(R¹⁹)(C(O)OR²⁰), -(CH₂)ₙC(R¹⁹)₂CH(C(O)OR²⁰)₂, -C(O)O-(CH₂)ₙ-(O-(CH₂)ₙ)ₚ-OR¹⁸ and -(CH₂)ₙ-(O-(CH₂)ₙ)ₚ-OR¹⁸, where n is independently an integer from 0 to 10, p is independently an integer from 0 to 6, B can be hydrogen or a halogen (i.e., fluorine, chlorine, bromine, and/or iodine), R¹⁹ can independently be hydrogen, a halogen such as fluorine, chlorine, bromine or iodine, a linear or branched C₁ to C₁₀ alkyl group or C₄ to C₁₂ cycloalkyl group or a linear or branched C₁ to C₁₀ halogenated alkyl group or C₄ to C₁₂ halogenated cycloalkyl group, R¹⁸ can independently be hydrogen, a linear or branched C₁ to C₁₀ alkyl group or C₄ to C₁₂ cycloalkyl group or a linear or branched C₁ to C₁₀ halogenated alkyl group or halogenated C₄ to C₁₂ cycloalkyl group, R²⁰ is not readily cleavable by a photoacid generator and can independently be a linear or branched C₁ to C₁₀ alkyl group or C₄ to C₁₂ cycloalkyl group or a linear or branched C₁ to C₁₀ halogenated alkyl group or C₄ to C₁₂ halogenated cycloalkyl group, and R¹⁷ is not readily cleavable by a photoacid generator and can independently be hydrogen, linear or branched C₁ to C₁₀ alkyls or halogenated alkyls, a monocyclic or polycyclic C₄ to C₂₀ cycloaliphatic or halogenated cycloalkyl moiety, a cyclic ether, a cyclic ketone or a cyclic ester (lactone), where each of the cyclic ether, ketone and ester can be halogenated or not. Exemplary cycloaliphatic moieties include, but are not limited to, unsubstituted cyclopropyl, cyclobutyl, cyclopentyl, cyclohexyl groups as well as 1-adamantyl and 1-norbornene moieties. In addition, in some embodiments, repeat units of the present invention are derived from monomers represented by Formula D1:

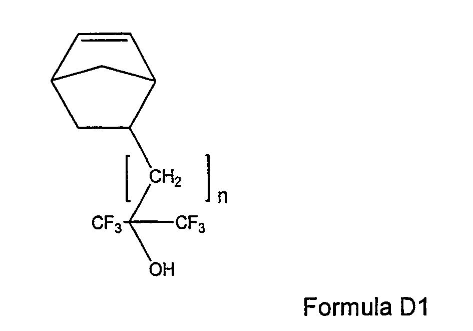

It will be noted that while polymers in accordance with the present invention encompass two or more types of repeat units derived from two or more of the monomer types represented by Formulae A, B, C and D, that such polymers encompass one repeat unit derived from a monomer in accordance with Formula A and at least one other type of repeat unit derived from a monomer in accordance with Formulae B, C or D.

The norbornene-type polymers of embodiments in accordance with the present invention are prepared by addition polymerization using neutral or cationic palladium based catalysts such as set forth in U.S. Patent No. 6,455,650, or nickel based catalysts as set forth in U.S. Patent No. 6,232,417. The pertinent parts of these patents are incorporated herein by reference. Exemplary palladium catalysts encompass, among others, trans-[Pd(NCMe)(OAC)(P(i-propyl)₃)₂]B(C₆F₅)₄, trans-[Pd(NCC(CH₃)₃)(OAC)(P(i-propyl)₃)₂]B(C₆F₅)₄, trans-[Pd(OC(C₆H₅)₂)(OAC)(P(i-propyl)₃)₂]B(C₆F₅)₄, trans-[Pd(HOCH(CH₃)₂)(OAc)(P(i-propyl)₃)₂]B(C₆F₅)₄, trans-[Pd(NCMe)(OAc)(P(cyclohexyl)₃)₂]B(C₆F₅)₄, Pd(OAc)₂(P(cyclohexyl)₃)₂, Pd(OAc)₂(P(i-propyl)₃)₂, Pd(OAc)₂(P(i-propyl)₂(phenyl))₂, trans-[Pd(NCMe)(OAc)(P(cyclohexyl)₂(t-butyl))₂]B(C₆F₅)₄, and mixtures thereof.

Exemplary nickel catalysts encompass, among others, (toluene)bis(perfluorophenyl) nickel, bis(tetrahydrofuran)bis(perfluorophenyl) nickel, (dimethoxyethane)bis(2,4,6-tris(trifluoromethylphenyl)) nickel, bis(dioxane)bis(perfluorophenyl) nickel, bis(ethylacetate)bis(perfluorophenyl) nickel and mixtures thereof.

Some embodiments in accordance with the present invention encompass a directly photoimageable polymer. Such embodiments typically incorporate a suitable photo acid generator (PAG) and/or a crosslinking agent into a composition of the norbornene-type polymer and a solvent.

Such PAGs generally encompass triflates (e.g., triphenylsulfonium triflate), pyrogallol (e.g., trimesylate of pyrogallol), onium salts such as triarylsulfonium and diaryliodium hexafluoroantimonates, hexafluoroarsenates, trifluoromethanesulfonates, esters of hydroxyimides, α,α'-bis-sulfonyl-diazomethanes, sulfonate esters of nitro-substituted benzyl alcohols and napthoquinone-4-diazides. Other useful PAGs are known and reported in Reichmanis et al., Chem. Mater. 3, 395, (1991).

Suitable crosslinker materials include, among others, melamine monomers, melamine polymers, alkoxymethyl melamines, urea-formaldehyde resins, glycoluril-formaldehyde resins and mixtures thereof.

As mentioned, such directly photoimageable embodiments of the present invention also contain a solvent. Exemplary solvents include, but are not limited to, PGMEA (propylene glycol methylether acetate), ethyl lactate, cyclohexanone, and the like, where the specific solvent selected does not have significant adverse effect on the performance of the directly photoimageable polymer.

It will be understood that the directly photoimageable embodiments of the present invention can encompass other materials such as crosslinking agents, dissolution rate modifiers, base quenchers and the like that generally are employed to enhance image forming capability. It will also be understood that such embodiments can be either positive acting or negative acting photoimageable compositions. Thus, such a composition having repeating units derived from monomers represented by Formula B are generally positive acting (positive tone). Such a composition having repeating units derived from monomers represented by Formula C rather than Formula B are generally negative acting (negative tone). In addition, the positive and negative tone compositions in accordance with embodiments of the present invention will encompass a suitable PAG and negative tone compositions will also encompass a suitable crosslinking agent (also referred to as a crosslinker). However, it should be realized that for some positive tone embodiments, appropriate repeat units derived from monomers in accordance with Formula C are within the scope of the present invention. Similarly, for some negative tone embodiments, appropriate repeat units derived from monomers in accordance with Formula B are within the scope of the present invention. Appropriate repeat units meaning those that will not prevent the embodiment from acting as a positive tone or negative tone composition, respectively.

The directly photoimageable compositions in accordance with the present invention are prepared by combining an imageable polymer, a PAG and/or crosslinker, and a solvent with any one or more of the aforementioned optional components or additives using conventional methods. Generally such directly photoimageable compositions contain between about 0.5 to 20 wt. % PAG and/or crosslinker (based on the total weight of the imageable polymer employed) are initially about 50 to 90 wt. % solvent (based on the total of the directly photoimageable composition). Where a base quencher is employed, generally 1 wt. % or less of such additive (based on the total weight of the imageable polymer employed) is provided. Where a dissolution rate modifier is employed, generally from about 5 to 25 wt. % (based on the total weight of the imageable polymer employed) is provided. It will be understood that when selected portions of a layer of such a directly photoimageable composition are exposed to actinic radiation of an appropriate wavelength and energy, such exposed regions undergo a transformation such that, for positive tone compositions, the exposed regions become more soluble than non-exposed regions. Thus treating the layer, after exposure, with an appropriate material, generally referred to as a developer, will result in the preferential removal of the exposed regions. For a negative tone composition, the exposure of selected regions of the layer to appropriate actinic radiation causes the exposed regions to become less soluble than non-exposed regions such that treating the layer after exposure will result in the preferential removal of the non-exposed regions.

Other embodiments in accordance with the present invention are useful as low dielectric constant (low-K) layers such as passivation layers and interlayer dielectric materials such as are employed in the manufacture of microelectronic devices. The compositions employed by these other embodiments can be directly photodefinable or not.

The term passivation layer refers to a layer of dielectric material disposed over a microelectronic device where such layer is typically the last such layer so disposed and is patterned to form openings therein that provide for making contact to such microelectronic device (contact holes). The term interlayer dielectric layer (ILD) refers to a layer of dielectric material disposed over.a first pattern of conductive traces and between such first pattern and a second pattern of conductive traces. Such ILD layer is typically patterned to form openings therein (generally referred to as "vias") to provide for electrical contact between the first and second patterns of conductive traces in specific regions. Other regions of such ILD layer are devoid of vias and thus prevent electrical contact between the conductive traces of the first and second patterns in such other regions. Thus for directly photodefinable embodiments, in accordance with the present invention, that are used for passivation or ILD layers, generally no additional layer is needed to define and form contact holes or vias.

While it should be realized, that in some embodiments of the present invention such polymer compositions can be directly photoimageable, in other embodiments, such polymer compositions are not directly photoimageable. Therefore, some such low-K embodiments can encompass repeating units derived from monomers represented by Formula A and any and all combinations of, repeat units derived from monomers represented by Formulae B, C and D. Where such compositions encompass repeat units derived from monomers represented by Formulae B and/or C, such can be made to be directly photoimageable or not. Whereas, compositions having repeating units derived only from monomers represented by Formulae A and D are not directly photoimageable.

Advantageously, the dielectric constant of the polymers in accordance with embodiments of the present invention can be adjusted by and through the selection of the pendant groups encompassed by the repeating units of such polymers. Thus it is generally found that where a polymer of the present invention has pendant groups that include aromatic, nitrogen, Br or Cl moieties, a higher dielectric constant is observed than for an analogous polymer having pendant groups that include alkyl, F and/or ether moieties. In some embodiments, the incorporation of repeating units derived from monomers represented by Formula D is used to affect such control of dielectric constant as well as other physical properties such as glass transition temperature, etch resistance, coefficient of thermal expansion (CTE) and the like.

The inclusion of such monomers in the forming of a polymer in accordance with the present invention should result in polymers having advantageous properties. For example, a relatively low refractive index and dielectric constant, and relatively high glass transition temperatures (Tg), reduced moisture absorption and increased resistance to plasma etching conditions (for example as might be found in the manufacture of microelectronic devices), as compared to analogous polymers without such high silicon content repeat units. Further it should be recognized that in addition to varying the selection of specific monomers represented by Formulae B, C and D for forming polymers of the present invention, the relative ratios of such monomers selected can be varied to achieve specific characteristics.

Still other embodiments of the present invention are useful as a sacrificial material in the manufacture of microelectronic devices. That is to say a material that after being disposed on a substrate, could be removed in whole or in part, to provide air gaps that would be useful, for example, in an insulating structure. In some embodiments such a sacrificial material is overlaid with another material that is not sacrificial and the removal, in whole or in part, is performed by heating the sacrificial material to a temperature sufficiently high to cause the gaseous decomposition of such material where such gaseous by-products escape through the overlying material to form the air gap. Methods for forming air gap structures are exemplified in the aforementioned US Patent No. 6,610,593 to Kohl et al., which is incorporated, in pertinent part, herein.

Still other embodiments of the present invention are useful as etch selective layers. That is to say, a layer formed overlying a substrate where such layer is patterned using a separate photoimageable layer which can be removed or not. Once patterned, the etch selective layer is used to form an image of the formed pattern in an underlying layer or in the substrate itself. Generally speaking, such etch selective layers are employed where the transfer of the pattern to the layer underlying such etch selective layer or to the substrate requires conditions that a photoresist layer can not adequately withstand. That is to say where the photoresist layer would lose pattern definition during the pattern transfer, generally a dry etching process. Advantageously, embodiments of the present invention allow for the incorporation of repeating units derived from monomers represented by Formula A as well as the relative ease of incorporating other repeating units derived from monomers represented by one or more of Formula B, C and D. In this manner a polymer of superior physical properties is obtained.

Referring now to the drawings, exemplary embodiments in accordance with the present invention, are shown. It will be understood that these drawings are for illustrative purposes only and are not to be construed as limiting the scope and spirit of the present invention.

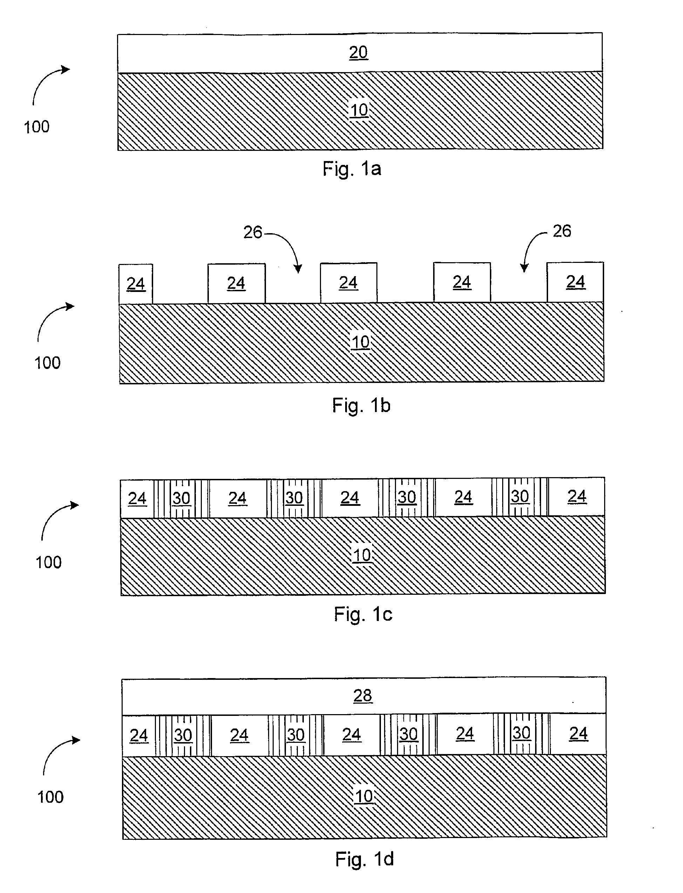

FIG. 1a is a cross-sectional representation of a portion 100 of a semiconductor structure encompassing a semiconductor substrate 10 having a dielectric layer 20 disposed thereon. Dielectric layer 20 is a low dielectric constant (low-K) polymeric material that encompass two or more different types of repeat units derived from norbornene-type monomers, where at least one such type of repeat unit has a polyhedral oligosilsesquioxane pendant group. Substrate 10 is any appropriate semiconductor substrate, for example a silicon wafer, and is depicted in a simplified manner for ease of understanding only. Thus while not shown, it should be realized that substrate 10 can encompass multiple discrete layers, conductive regions, transistors, diodes and the like, and that such a more complex substrate is within the scope and spirit of the present invention. While typically low-K dielectric layer 20 is provided to substrate 10 by a spin coating process, such as is known in the semiconductor processing arts, any other appropriate method for providing layer 20 to substrate 10 can be employed, for example a spray coating method.

Fig. 1b shows low-K dielectric layer 20 after it patterning to form low-K dielectric portions 24 and openings 26. Such patterning can be accomplished by any appropriate method, for example a photolithography step encompassing the application and patterning of a photoresist layer (not shown) and subsequent etching of layer 20 (FIG. 1a). Advantageously, in some embodiments of the present invention, layer 20 can encompass a directly photodefinable polymer composition, thus allowing such patterning to form portions 24 and openings 26 without the use of extra steps and materials such as would be necessary for a non-directly photodefinable polymer.

Referring now to FIG. 1c, the structure of FIG. 1b is shown after a layer of conductive material (not shown) is provided over substrate 10. Such a conductive layer can be provided by a chemical deposition process, a physical deposition process or any other appropriate means. Typically the conductive material encompasses copper, aluminum, alloys of copper and/or aluminum or any other appropriate conductive material or combination of conductive materials. After such a layer is formed, generally a planarization process, for example a chemical mechanical planarization (CMP) process, is used to both planarize the conductive layer with respect to low-K portions 24 and singulate portions of the conductive layer to form conductive traces 30. It will be understood that such singulated conductive portions of traces 30 are distinct from one another being insulated or separated by dielectric portions 24.

In FIG. 1d, the structure of FIG. 1c is shown after a second dielectric layer 28 is provided. Second layer 28 is a dielectric or insulating layer such as a polymer composition in accordance with embodiments of the present invention or any other appropriate dielectric material, for example an inorganic material such as a silicon oxide. Thus, portion 100 shown in Fig. 1d shows the forming of a number of conductive regions or traces 30 that are distinct and spaced from one another by low-K dielectric portions 24 and overlaid with dielectric layer 28. By virtue of layer 28, it will be understood that second low-K portions and second conductive portions (not shown) can be formed overlying layer 28 and that such second portions and traces will be distinct from portions 24 and traces 30. It will be further understood that the teaching evident in FIGs. 1a-1d and the description of such herein, are sufficient to instruct an ordinarily skilled artisan to form alternate structures with any number of layers of conductive traces spaced from one another by low-K portions in a lateral direction and elevationally by additional, overlaid dielectric layers.

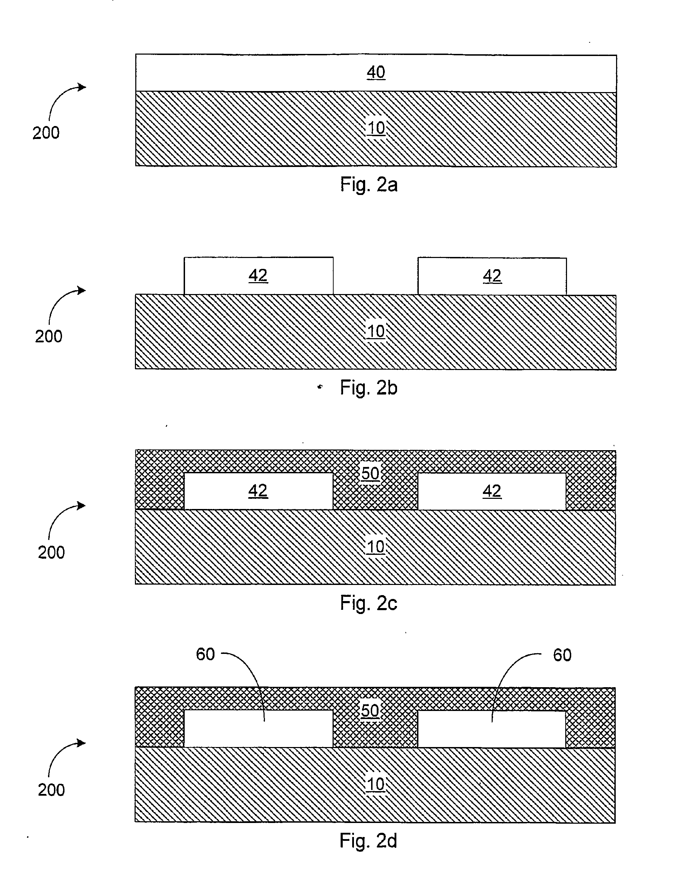

Turning now to FIG. 2a, portion 200 of semiconductor substrate 10 is shown at a preliminary step in the forming of "air gap" structures in accordance with embodiments of the present invention. Specifically, layer 40, encompassing a sacrificial material in accordance with embodiments of the present invention is shown overlying substrate 10. As discussed above, layer 40 is provided to substrate 10 in any appropriate manner and such layer encompasses two or more different types of repeat units derived from norbornene-type monomers, where at least one such type of repeat unit has a polyhedral oligosilsesquioxane pendant group.

In FIG. 2b, layer 40 is shown after patterning to form portions 42. For some embodiments, the forming of portions 42 is performed using a photosensitive layer such as a photoresist to define a pattern and an etch process to create portions 42 from layer 40. In other embodiments, layer 40 encompasses a directly photodefinable polymer composition, thus allowing such patterning to form portions 24 and openings 26 without the use of extra steps and material such as would be necessary for a non-directly photodefinable polymer.

In FIG. 2c, the structure of FIG. 2b is shown after second layer 50 is provided to substrate 10 and portions 42 in an overlying relation. Second layer 50 is typically a solid layer encompassing a material such as a silicon oxide material. Then, heat is applied to portion 200 causing the polymer material of portions 42 to decompose into one or more gaseous decomposition products. Such one or more of these gaseous decomposition products pass through second layer 50 thus causing "air gaps" 60 to be formed. It will be understood that by "air gaps" it is meant a closed interior space or spaces previously occupied by a sacrificial material where that sacrificial material has been converted to gaseous by products. While not wishing to be bound by any theory, it is believed that the gaseous by products are removed by a diffusion process through layer 50. Thus selection of the material for layer 50 should realize that such gaseous by products are likely to be removed therethrough to allow air gaps 60 to form.

Generally the decomposition reaction of the sacrificial material of portions 42 is induced by providing a temperature sufficient high (decomposition temperature) to cause the decomposition of the specific material provided. The decomposition temperature should be compatible with the various other components of the portion 200 so as not to destroy the integrity thereof, other than the removal of the material of potions 42 form air gaps 60 depicted in FIG. 2d. Typically, the sacrificial material used to form portions 42 is a polymeric material that encompass two or more different types of repeat units derived from norbornene-type monomers, where at least one such type of repeat unit has a polyhedral oligosilsesquioxane pendant group. In some embodiments, such material is directly photodefinable, while in other embodiments such polymeric material is defined by the use of photolithography and etch processes. The specific temperature where a polymeric material will decompose is a function of the materials composition, but generally the decomposition temperature is less than about 475°C and more than about 300°C. More typically, the polymer material is formed such that the decomposition temperature is more than about 320°C and less than about 425°C. However, it should be realized that materials in accordance with the present invention provide for the forming of polymers having specific compositions that will provide optimum decomposition temperatures for a specific use or application. Advantageously, such polymer formulations, in accordance with the present invention are generally sufficiently thermally stable so that the material of layer 50 can be provided and prepared, if needed, for the passage of the gaseous decomposition products therethrough.

It should be further noted that any one or more of the herein described layers or portions can be encompass multiple sub-layers, as may desired for different fabricating techniques. For example, layer 50 in FIG. 2c can encompass a first sub-layer (not shown) having the same elevational level as portions 42 and a second sub-layer (not shown) overlying the first sub-layer and portions 42. Also, the indication that a layer is applied to an underlying layer is not intended to preclude the presence of an intermediate layer that might be employed, for example, to enable the adequate bonding of one layer to another.

The forgoing methodology can be applied to form air gap(s) in a variety of electrical devices and particularly in relation to' electrical interconnects in integrated circuits and other electronic packages. The air gap(s) may be used on opposite sides of a conductive member or members in both interplanar and intraplanar arrangements to provide a low dielectric insulator with dielectric constants generally less than about 2, in another embodiment less than about 1.5, in yet another embodiment, less than about 1.25, and in still another embodiment, about 1.0. The lower the capacitance of the dielectric structure between conductive traces, the faster the electrical signal that can be transmitted through such conductors and the lower the crosstalk therebetween.

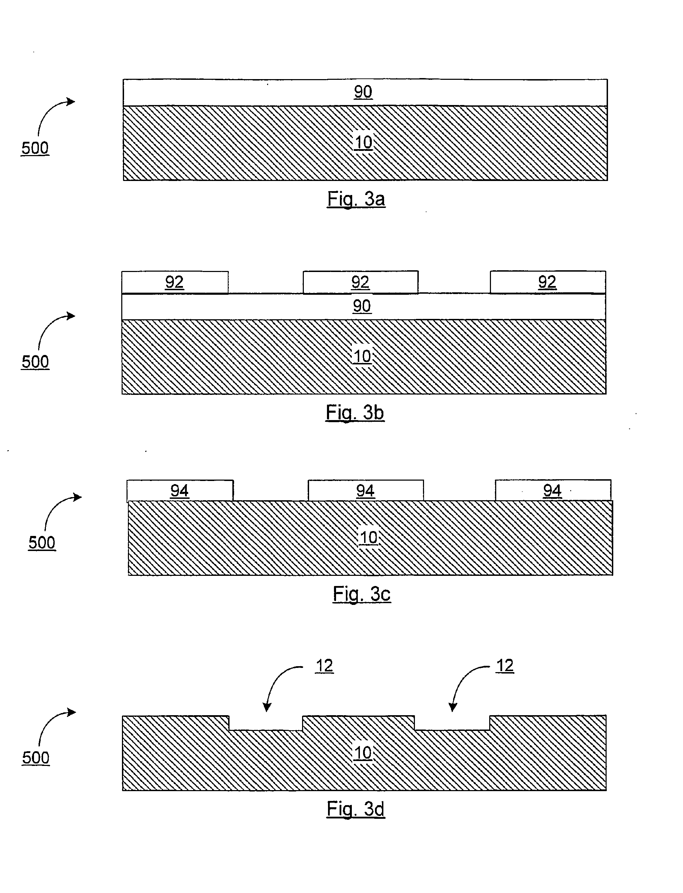

Turning now FIGs. 3a-3d, simplified cross-sectional representations of a portion of a semiconductor structure, illustrating an etch selective layer embodiment in accordance with the present invention are provided. In FIG. 3a, portion 500 includes semiconductor substrate 10 having layer 90 of an etch selective material disposed thereon. The material of layer 90, encompasses two or more different types of repeat units derived from norbornene-type monomers, where at least one such type of repeat unit has a polyhedral oligosilsesquioxane pendant group and is provided to substrate 10 in any appropriate manner as discussed for previously described embodiments of the present invention.

Turning to FIG. 3b, the structure of FIG. 3a is shown after a layer of a photoresist material is provided over layer 90 and patterned to form photoresist portions 92. In some embodiments in accordance with the present invention an optional capping layer (not shown) is formed intervening between layer 90 and the photoresist layer to eliminate any interaction therebetween. Where such a capping layer is used, generally it is a silicon oxide material, although any other appropriate material may be employed.

In FIG. 3c, the structure of FIG. 3b is depicted after photoresist portions 92 are employed as masking elements to allow their duplication in underlying layer 90 and form etch selective portions 94. As shown, photoresist portions 92 are removed. It should be realized that etch selective portions 94 are formed for masking substrate 10 and allow the forming of a pattern therein. Generally, such portions 94 are employed rather that the previously formed photoresist portions 92 due to their higher resistance to the conditions for forming the pattern in substrate 10.

Referring now to FIG. 3d, substrate 10 is shown after trench portions 12 are formed therein and etch selective portions 94 removed. It should be realized that the specific processes used to form trench portions 12 are a function of the material that substrate 10 encompasses. It should be realized that while FIGs. 3a-3d describe the forming of an etch selective layer 90 and etch selective portions 94 using a photoresist layer, in some embodiments in accordance with the present invention, layer 90 encompasses a directly definable polymer composition and hence such a photoresist layer is not employed.

It is believed that the polycycloolefinic polymers utilized in practicing this invention according to the embodiments described above are uniquely suited for semiconductor device manufacturing. Such materials advantageously remain mechanically stable until the decomposition temperature (Tg) is reached, enabling the polymer to endure the rather harsh processing steps (e.g., repeated heat cycles) often encountered during semiconductor manufacture. The disadvantage with the prior art polymers is that their Tg values are well below their decomposition temperatures, leading to mechanical failure before the decomposition temperature is reached.

### Examples

The following illustrative examples and exemplary formulae for polymers in accordance with the present invention are for illustrative purposes only and are not to be construed as limiting the scope and spirit of the present invention. Unless otherwise specified, all glassware used in the following examples was vacuum dried, transferred into a N₂ purged glovebox and assembled therein to create a reaction vessel. All reagents listed in the examples were added to the reaction vessel in the glovebox and the polymerization initiated. Unless otherwise specified, all molecular weights of the polymers were determined by gel permeation chromatography (GPC) using a poly(styrene) standard. Where compositional data is provided, such was obtained using ¹³C NMR analysis unless otherwise noted. The methods used for determining optical density (OD) and etch rate are as described below, before the Imaging Examples.

### Example 1

### Polymerization of MCPNB:BuLacEsNB:HFANB

The methylcyclopentylester of 5-norbornene carboxylic acid (MCPNB) 5.00 g, 0.0227 mol), tetrahydro-2-oxo-3-furanyl ester of 5-norbornene carboxylic acid ((BuLacEsNB) 3.78 g, 0.0171 mol), and α,α-bis(trifluoromethyl) bicyclo[2.2.1]hept-5-ene-2-ethanol ((HFANB) 4.67 g, 0.0171 mol) were dissolved in 30 mL of toluene. To this solution was added 10 mL of a 0.114 M toluene solution of (η⁶-toluene)Ni(C₆F₅)₂ (NiArF) 0.00114 mol). The mixture was allowed to stir at room temperature for 16 hours (h) and then poured into hexane to precipitate the polymer. The polymer was separated by filtration and dried at 50 °C under vacuum to a constant weight. Yield 9.2 g (69%). Mw=33,400, Mn=15,300. OD= 0.34 (absorbance units/micron).

### Example 2

### Polymerization of MCPNB:BuLacEsNB:HFANB:NB1020

MCPNB (5.00 g, 0.0227 mol), BuLacEsNB (3.98 g, 0.0179 mol), HFANB (4.92 g, 0.0179 mol), and norbornenylethylcyclopentyl-POSS (NB1020 from Hybrid Plastics, 1.22 g, 0.00120 mol) were dissolved in 30 mL of toluene. To this solution was added 10.5 mL of a 0.114 M toluene solution of NiArF. The mixture was allowed to stir at room temperature for 16 h and then poured into hexane to precipitate the polymer. The polymer was separated by filtration and dried at 50 °C under vacuum to a constant weight. Yield 13.5 g (89%). Mw=40,800, Mn=18,400. The polymer was determined to contain approximately 35 mole percent (mol%) MCPNB, 20 mol% BuLacEsNB, 25 mol% HFANB, 18 mol% 5-norbornene carboxylic acid, and 2 mol% NB1020. OD= 0.29 (absorbance units/micron).

### Example 3

### Polymerization of MCPNB:BuLacEsNB:HFANB:NB1020

MCPNB (5.45 g, 0.0248 mol), BuLacEsNB (4.69 g, 0.0211 mol), HFANB (5.79 g, 0.0211 mol), and NB1020 (3.06 g, 0.00300 g) were dissolved in 30 mL of toluene. To this solution was added 12.3 mL of a 0.114 M toluene solution of NiArF. The mixture was allowed to stir at room temperature for 16 h and then poured into hexane to precipitate the polymer. The polymer was separated by filtration and dried at 50 °C under vacuum to a constant weight. Yield 13.5 g (70%). Mw=33,900, Mn=15,500. The polymer was determined to contain approximately 35 mol% MCPNB, 25 mol% BuLacEsNB, 29 mol% HFANB, 8 mol% 5-norbornene carboxylic acid, and 3 mol% NB1020. OD=0.25 (absorbance units/micron).

### Example 4

### Homopolymerization of HFANB

HFANB (65.0 g, 0.237 mol), was added to a 250 mL pressure reactor along with 96 mL of toluene. The reactor was pressurized with 1 psig nitrogen and 8 psig ethylene for 30 min at room temperature. The catalyst, palladium bis(i-propyldiphenylphosphine) diacetate (0.0065 g, 0.0096 mmol), and cocatalyst, N,N-dimethylanilinium tetrakis(pentafluorophenyl)borate ((DANFABA) 0.038 g, 0.047 mmol), were dissolved in 2 mL and 3 mL of methylene chloride, respectively, and then added to the reactor. The reactor was then heated to 80°C for 18 hours. The reactor was then cooled and vented. The reaction mixture was added to hexane (10-fold volumetric excess) to precipitate the polymer which was filtered and dried overnight at 70 °C under vacuum. Yield 39.0 g (60%). Mw=19,600, Mn=8,280. The Etch Rate= 1.5 times that of the novolac standard.

### Example 5

### Polymerization of HFANB and NB1020

HFANB (24.7 g, 0.0899 mol) and NB1020 (10.2 g, 0.0100 mol) were dissolved in 100 mL of toluene. To this solution was added, palladium bis(tricyclohexylphosphine) diacetate (0.0314 g, 0.0400 mmol), DANFABA (0.160 g, 0.200 mmol) and hexene-1 (12.6 g, 0.150 mol). The solution was heated to 80 °C and stirred for 18 hours. The polymer solution was then filtered through a 0.22 µm Teflon^{®} filter and the filtrate was then added into heptane to precipitate the polymer. The resulting polymer separated by filtration and dried in a vacuum oven at 75°C for 18 hrs. Yield 14.40 g (41%). Mw=17,400, Mn=6,320.

The HFANB/NB1020 polymer (11 g) was dissolved in toluene (55 mL) and to the resulting solution was added, glacial acetic acid (28 mL), 30% hydrogen peroxide (14 mL) and deionized water (14 mL). The polymer solution was heated to 80°C and stirred for 2.5 hours. The polymer solution was then washed 4 times with deionized water, concentrated, added drop wise into heptane for 15 min and filtered. The resulting polymer was dried in a vacuum oven at 80°C for 18 hours and found to weigh 9.05 g (82% recovery). The polymer's molecular weight was measured and found to be: Mw=18,300, Mn=7,320. Etch Rate= 1.15 times the novolac standard.

A comparison of the Optical Density of the polymers of Examples 1, 2 and 3 shows that by incorporating NB1020 into the polymer, the optical density of such polymer is advantageously lowered. Comparing the Etch Rate data of Examples 4 and 5 shows that by incorporating NB1020 into the polymer, the etch resistance of such polymer is advantageously increased. A skilled artisan will realize that while these advantages are demonstrated above for the incorporation of NB1020, such should not be specific to NB1020. Rather, such advantages should be realized by polymers that incorporate any of the POSS type repeating units.

### Example 6

### Polymerization of HFANB and NB1020

HFANB (4.94 g, 0.0180 mol) and NB1020 (2.04 g, 0.00200 mol) were dissolved in 120 mL of toluene. To this solution was added, palladium bis(tricyclohexylphosphine) diacetate (0.0063 g, 0.00800 mmol), DANFABA (0.0321 g, 0.0401 mmol) and hexene-1 (0.63 g, 0.0075 mol). The solution was heated to 80°C and stirred for 18 hours. After cooling, the solution was added into heptane to precipitate the polymer. The resulting polymer was filtered and dried in a vacuum oven at 75°C for 18 hours. Yield 5.87 g (84%). Mw=58,400, Mn=11,600. The polymer composition was determined to be 89:11 HFANB:NB1020.

### Example 7

### Polymerization of HFANB and NB1020

HFANB (4.94 g, 0.0180 mol) and NB1020 (2.04 g, 0.00200 mol) were dissolved in 120 mL of toluene. To this solution was added, palladium bis(tricyclohexylphosphine) diacetate (0.0063g, 0.0080 mmol), DANFABA (0.0321 g, 0.0401 mmol) and hexene-1 (1.68 g, 0.0200 mol). The solution was heated to 80°C and stirred for 18 hours. After cooling, the solution was added into heptane to precipitate the polymer. The resulting polymer was filtered and dried in a vacuum oven at 75°C for 18 hours. Yield 4.72 g (68%). Mw=22,400, Mn=7,100. The polymer composition was determined to be 88:12 HFANB:NB1020.

### Example 8

### Polymerization of MeOAcNB and NB1038

5-norbornene-2-methanol acetate ((MeOAcNB) 5.82 g, 0.0350 mol) and norbornenylethylsilanolisobutyl POSS ((NB1038 from Hybrid Plastics), 14.6 g, 0.0150 mol) were dissolved in 95 g of ethyl acetate. The solution was then sparged with nitrogen. To this mixture was added 0.96 g of NiArF (0.00198 mol) in 5 g of ethyl acetate. The mixture was stirred overnight. To this reaction mixture was added 20 g of 30 percent hydrogen peroxide and 20 g of glacial acetic acid. The mixture was stirred for 7 hours. Toluene (50 mL) was added and the mixture was allowed to separate into a clear organic phase and a green aqueous phase. An additional 100 mL of toluene was added and the aqueous layer was separated. The organic phase was washed with deionized water (8 x 300 mL) to remove residual acid. The organic phase was concentrated by rotary evaporation and then added to 1 L of methanol. Solvent was decanted from the precipitated polymer. The polymer was dried at 80 °C under vacuum. Yield 14.9 g (73%). Mw=32900, Mn=17400. Dynamic TGA (thermogravimetric analysis) under nitrogen (10 °C/min) shows that the polymer is quite stable, less than 1 percent weight loss at 250 °C. However, above 300 °C, the polymer begins to lose weight dramatically. Above 500 °C, less than 3% char remains. This sort of thermal behavior is desirable for sacrificial materials.

### Example 9

### Polymerization of HEANB and NB1038

Hydroxyethyl ester of 5-norbornene carboxylic acid ((HEANB) 9.57 g, 0.0525 mol) and NB1038 (21.8 g, 0.0225 mol) were dissolved in 125.2 g of toluene. The solution was then sparged with nitrogen. To this mixture was added 7.27 g of NiArF (0.0150 mol) in 35 g of toluene and the mixture was stirred overnight. The mixture was diluted with 75 g of THF and to this solution was added 100 g of 30 percent hydrogen peroxide and 100 g of glacial acetic acid. The mixture was heated to 70 °C for 2 hours. After cooling, two phases formed. The aqueous layer was separated and the organic phase was extracted again with 75 g of glacial acetic acid. The organic layer was then concentrated by rotary evaporation and then added to 4 L of water. The precipitated polymer was filtered, dissolved in THF (120 g), and then reprecipitated in water. The reprecipitation was repeated once. The polymer precipitate was dried at 80 °C under vacuum. Yield 25.4 g (81 %). Mw=16500, Mn=10080. The composition was determined to be 68 mol% HEANB and 32 mol% NB1038.

### Example 10

### Polymerization of MeOAcNB:HEANB:NB1038

MeOAcNB (0.50 g, 0.0030 mol), HEANB (0.090 g, 0.00049 mol) and NB1038 (1.45 g, 0.0015 mol) were dissolved in 8.3 g of toluene. To this solution was added 0.0485 g of NiArF (0.000100 mol). The sample was allowed to polymerize after which time an aliquot was removed and the molecular weight measured. Mw= 62,300 and Mn=29,100.

### Example 11

### Polymerization of MeOAcNB:HEANB:NB1038

MeOAcNB (2.16 g, 0.0130 mol), HEANB (0.360 g, 0.00200 mol) and NB1038 (4.85 g, 0.00500 mol), triethylsilane (0.10 g, 0.00083 mol), DANFABA (1.0 mL of a 0.03 M solution in dichloromethane), tricyclohexylphosphine (1.0 mL of a 0.015 M solution in dichloromethane), and palladium diacetate (1.0 mL of a 0.015 M solution in dichloromethane) were dissolved in sufficient anisole to yield 13 mL of solution. The mixture was heated to 85 °C overnight, cooled and then poured into methanol. The precipitated polymer was collected and dried at 80 °C in a vacuum oven. Yield 5.01 g (68%). Mw=15000, Mn=8230.

### Example 12

### Polymerization of MeOAcNB:HEANB:NB1038

MeOAcNB (2.16 g, 0.0130 mol), HEANB (0.360 g, 0.00200 mol) and NB1038 (4.85 g, 0.00500 mol), triethylsilane (0.10 g, 0.00083 mol), DANFABA (0.0240 g, 0.0500 mmol), and [palladiumbis(tri-*i*-propylphosphine) (acetonitrile)(acetate)][tetrakis(pentafluorophenyl)-borate] (Pd1206) (0.0121 g, 0.0100 mmol) were dissolved in sufficient toluene to yield 13 mL of solution. The mixture was heated to 85 °C overnight, cooled and then poured into methanol. The precipitated polymer was collected and dried at 80 °C in a vacuum oven. Yield 6.12 g (83%). Mw=25100, Mn=9380.

### Example 13

### Polymerization of MeOAcNB:HEANB:NB1022

MeOAcNB (2.16 g, 0.0130 mol), HEANB (0.360 g, 0.00200 mol) and norbornenylethylisobutyl POSS ((NB1022) from Hybrid Plastics, 4.69 g, 0.00500 mol), triethylsilane (0.10 g, 0.00083 mol), and DANFABA (1.0 mL of a 0.012 M solution in dichloromethane) were dissolved in sufficient toluene to yield 13 mL of solution. The mixture was heated to 80 °C. By syringe, [palladiumbis(tri-i-propylphosphine)(acetonitrile)(acetate)][tetrakis(pentafluoro-phenyl)borate] (1.0 mL of a 0.004 M solution in dichloromethane) was added to the mixture. After 18 hours, the mixture was cooled and then added to a methanol/water (12/1) mixture. The precipitated polymer was collected and dried at 80 °C in a vacuum oven. Yield 6.90 g (96%). Mw=12,600, Mn=6,200. Dynamic TGA (thermogravimetric analysis) under nitrogen (10 °C/min) shows that the polymer is quite stable, less than 1 percent weight loss at 250 °C. However, above 300 °C, the polymer begins to lose weight dramatically. Above 500 °C, less than about 3% char remains. This sort of thermal behavior is desirable for sacrificial materials.

### Example 14

### Polymerization of MeOAcNB:HEANB:NB1022

MeOAcNB (1.83 g, 0.0110 mol), HEANB (0.73 g, 0.0040 mol) and NB1022 (4.69 g, 0.00500 mol), triethylsilane (0.10 g, 0.00083 mol), and DANFABA (1.0 mL of a 0.012 M solution in dichloromethane) were dissolved in sufficient toluene to yield 13 mL of solution. The mixture was heated to 80 °C. By syringe, [palladiumbis(tri-i-propylphosphine)(acetonitrile)(acetate)] [tetrakis(pentafluoro-phenyl)borate] (1.0 mL of a 0.004 M solution in dichloromethane) was added to the mixture. After 18 hours, the mixture was cooled and then added to a methanol/water (12/1) mixture. The precipitated polymer was collected and dried at 80 °C in a vacuum oven. Yield 6.93 g (96%). Mw=12800, Mn=6500.

### Example 15

### Polymerization of MeOAcNB:HEANB:NB1022

MeOAcNB (4.57 g, 0.0275 mol), HEANB (1.82 g, 0.0100 mol) and NB1022 (11.7 g, 0.0125 mol), triethylsilane (0.15 g, 0.0013 mol), and DANFABA (0.5 mL of a 0.015 M solution in dichloromethane) were dissolved in sufficient toluene to yield 33 mL of solution. The mixture was heated to 80 °C. By syringe, [palladiumbis(tri-i-propylphosphine)(acetonitrile)(acetate)][tetrakis(pentafluoro-phenyl)borate] (0.5 mL of a 0.005 M solution in dichloromethane) was added to the mixture. After 18 hours, the mixture was cooled and then added to methanol. The precipitated polymer was collected and dried at 80 °C in a vacuum oven. Yield 12.8 g (71%). Mw=33,000 and Mn=18,500.

### Example 16

### Polymerization of MeOAcNB:HEANB:NB1022

MeOAcNB (2.91 g, 0.0175 mol), HEANB (3.64 g, 0.0200 mol) and NB1022 (11.7 g, 0.0125 mol), triethylsilane (0.15 g, 0.0013 mol), and DANFABA (0.5 mL of a 0.015 M solution in dichloromethane) were dissolved in sufficient toluene to yield 33 mL of solution. The mixture was heated to 80 °C. By syringe, [palladiumbis(tri-i-propylphosphine)(acetonitrile)(acetate)] [tetrakis(pentafluoro-phenyl)borate] (1.0 mL of a 0.005 M solution in dichloromethane) was added to the mixture. After 18 hours, the mixture was cooled and then added to methanol. The precipitated polymer was collected and dried at 80 °C in a vacuum oven. Yield 10.5 g (57%). Mw=25,700 and Mn=14,600.

### Example 17

### Polymerization of MeOAcNB:HEANB:NB1022

The monomers, MeOAcNB (1.83 g, 0.0110 mol), HEANB (0.73 g, 0.0040 mol) and NB1022 ( 4.69 g, 0.005 mol), triethylsilane (0.070 g, 0.00062 mol), and DANFABA (1.0 mL of a 0.0060 M solution in dichloromethane) were dissolved in sufficient toluene to yield 13 mL of solution. The mixture was heated to 80 °C. By syringe, [palladiumbis(tri-i-propylphosphine)(acetonitrile)(acetate)] [tetrakis(pentafluoro-phenyl)borate] (1.0 mL of a 0.0020 M solution in dichloromethane) was added to the mixture. After 18 h, the mixture was cooled and then added to methanol. The precipitated polymer was collected and dried at 80 °C in a vacuum oven. Yield 5.94 g (82%). Mw=21,100 and Mn=11600.

### Example 18

### Polymerization of MeOAcNB:HEANB:NB1021

The monomers, MeOAcNB (1.99 g, 0.0120 mol), HEANB (0.73 g, 0.0040 mol) and norbornenylethylethyl POSS ((NB1021) from Hybrid Plastics, 2.97 g, 0.00400 mol), triethylsilane (0.070 g, 0.00062 mol), and DANFABA (1.0 mL of a 0.0060 M solution in dichloromethane) were dissolved in sufficient toluene to yield 13 mL of solution. The mixture was heated to 80 °C. By syringe, [palladiumbis(tri-i-propylphosphine)(acetonitrile)(acetate)] [tetrakis(pentafluoro-phenyl)borate] (1.0 mL of a 0.0020 M solution in dichloromethane) was added to the mixture. After 18 hours, the mixture was cooled and then added to methanol. The precipitated polymer was collected and dried at 80 °C in a vacuum oven. Yield 2.73 g (48%). Mw=21,000 and Mn=11,300.

### Example 19

### Polymerization of MeOAcNB:HEANB:NB1021

The monomers, MeOAcNB (0.42 g, 0.0025 mol), HEANB (0.09 g, 0.0005 mol) and NB1021(1.48 g, 0.00200 mol), triethylsilane (0.035 g, 0.00031 mol), and DANFABA (0.0048 g, 0.0066 mmol) were dissolved in toluene (4 mL). The mixture was heated to 80 °C. By syringe 1 mL of a dichloromethane solution of [palladiums bis (tri-isopropylphosphine)(acetonitrile)(acetate)] [tetrakis(pentafluorophenyl)borate] (0.0024 g, 0.0020 mmol) was added to the mixture. After 18 hours, the mixture was cooled and then added to an excess of methanol. The precipitated polymer was collected and dried in a vacuum oven. Yield 1.02 g (66%). Mw=9,800 and Mn=4,870. The polymer was determined to contain approximately 50 mol% MeOAcNB, 39 mol% NB1021, and 11 mol% HEANB.

### Example 20

### Polymerization of MeOAcNB:HEANB:NB1021

The monomers, MeOAcNB (0.42 g, 0.0025 mol), HEANB (0.09 g, 0.0005 mol) and hydroxyethyl ester of 5-norbornene carboxylic acid 1.48 g, 0.00200 mol), triethylsilane (0.022 g, 0.00020 mol), and DANFABA (0.024 g, 0.030 mmol) were dissolved in toluene (4 mL). The mixture was heated to 80 °C. By syringe a 1 mL solution of [palladium bis(tri-i-propylphosphine) (acetonitrile)(acetate)][tetrakis(pentafluorophenyl)borate] (0.0126 g, 0.104 mmol) in dichloromethane was added to the mixture. After 18 hours, the mixture was cooled and then added to methanol. The precipitated polymer was collected and dried in a vacuum oven. Yield 1.56 g (78%). Mw=12,500 and Mn6,350.

### Example 21

### Polymerization of MeOAcNB:HEANB:NB1021

The monomers, MeOAcNB (5.65 g, 0.0340 mol), HEANB (1.24 g, 0.0068 mol) and NB1021 (20.16 g, 0.0272 mol), triethylsilane (0.161 g, 0.00139 mol), and DANFABA (0.033 g, 0.041 mmol) were dissolved in toluene (18 mL). The mixture was heated to 80 °C. By syringe a 1 mL solution of [palladiumbis(tri-i-propylphosphine)(acetonitrile)(acetate)][tetrakis(pentafluorophenyl)borate] (0.0164 g, 0.0136 mmol) in dichloromethane was added to the mixture. After 18 hours, the mixture was cooled, diluted with 75 mL of toluene and then added to methanol. The precipitated polymer was collected and dried in a vacuum oven. Yield 21.8 g (81 %). Mw=33,100 and Mn=14,100. A small amount of unreacted NB1021 monomer was apparent in the GPC trace (- 1 %).

The polymer was dissolved in 110 g of toluene. To this mixture was added 55 g of glacial acetic acid and 55 g of hydrogen peroxide (30 %). This mixture was heated to 60 °C for 4 hours. After cooling, the mixture was allowed to separate into two phases in a separatory funnel. The organic phase was separated from the aqueous phase, washed with water (10 x 300 mL). Volatiles from the organic phase were removed by rotary evaporation. The remaining solid was dissolved in 110 g of toluene. The toluene solution was poured into methanol (2500 mL). The precipitated polymer was filtered and dried in a vacuum oven. Yield 18.6 g (69%). The molecular weight was found to be Mw=35,600 and Mn=15,200. No unreacted norbornenylethylethyl POSS monomer was visible in the GPC trace. The polymer was determined to contain approximately 50 mol% MeOAcNB, 39 mol% NB1021, and 11 mol% HEANB.

### Example 22

### Polymerization of MeOAcNB:HEANB:NB1021

The monomers, MeOAcNB (4.52 g, 0.0272 mol), HEANB (2.48 g, 0.0136 mol) and NB1021 (20.16 g, 0.0272 mol), triethylsilane (0.161 g, 0.00139 mol), and DANFABA (0.033 g, 0.041 mmol) were dissolved in toluene (18 mL). The mixture was heated to 80 °C. By syringe a 1 mL solution of [palladiumbis(tri-i-propylphosphine)(acetonitrile)(acetate)][tetrakis(pentafluorophenyl)borate] (0.0164 g, 0.0136 mmol) in dichloromethane was added to the mixture. After 18 hours, the mixture was cooled, diluted with 75 mL of toluene and then added to methanol. The precipitated polymer was collected and dried in a vacuum oven. Yield 14.7 g (54%). Mw=29,400 and Mn=15,600. A small amount of unreacted NB1021 monomer was apparent in the GPC trace (- 1 %).

The polymer was dissolved in 25 g of toluene. To this mixture was added 35 g of glacial acetic acid and 35 g of hydrogen peroxide (30 %). This mixture was heated to 60 °C for 4 hours. After cooling, the mixture was allowed to separate into two phases in a separatory funnel. The organic phase was separated from the aqueous phase, washed with water (10 x 300 mL). Volatiles from the organic phase were removed by rotary evaporation. The remaining solid was dissolved in 85 g of toluene. The toluene solution was poured into methanol (2500 mL). The precipitated polymer was filtered and dried in a vacuum oven. Yield 12.8 g (47%). The molecular weight was found to be Mw=30,400 and Mn=16,900. No unreacted norbornenylethylethyl POSS monomer was visible in the GPC trace. The polymer was determined to contain approximately 42 mol% MeOAcNB, 36 mol% NB1021, and 22 mol% HEANB.

### Example 23

### Polymerization of NB1021 and Norbornene

Norbornene (1.14 g, 12.1 mmol) and NB1021 (3.00 g, 4.05 mmol) were dissolved in toluene (12.6 g) and ethylacetate (5.15 g). The monomer solution was sparged with nitrogen then heated to 45 °C. A toluene (2 g) solution of NiArF (0.164 g, 0.338 mmol) was added. After 3 hours, a mixture of glacial acetic acid (19 mL) and hydrogen peroxide (30 %, 35 mL) and water (25-30 mL) was added to the reaction solution. The mixture was allowed to stir overnight. The aqueous layer was removed and the organic phase was washed with water 5 times. The organic phase was then poured into methanol (300 mL). The precipitated polymer was filtered and dried in a vacuum oven at 50 °C overnight. Yield 4.1 g (99%). Mw=114,000 and Mn=34,800.

### Example 24

### Polymerization of NB1021 and BuNB

Butylnorbornene ((BuNB) 1.82 g, 12.1 mmol) and NB1021 (3.00 g, 4.05 mmol) were dissolved in toluene (15.2 g) and ethylacetate (4.80 g). The monomer solution was sparged with nitrogen then heated to 45 °C. A toluene (2 g) solution of NiArF (0.164 g, 0.338 mmol) was added. After 3 hours, a mixture of glacial acetic acid (19 mL) and hydrogen peroxide (30 %, 35 mL) and water (25-30 mL) was added to the reaction solution. The mixture was allowed to stir overnight. The aqueous layer was removed and the organic phase was washed with water 5 times. The organic phase was then poured into methanol (300 mL). The precipitated polymer was filtered and dried in a vacuum oven at 50 °C overnight. Yield 4.84 g (99%). Mw=54,700 and Mn=18,900. The polymer was determined to contain approximately 75 mol% 5-butylnorbornene and 25 mol% NB1021. Dynamic TGA (thermogravimetric analysis) under nitrogen (10 °C/min) shows that the polymer is quite stable, less than 1 percent weight loss at 250 °C. However, above 300 °C, the polymer begins to lose weight dramatically. Above 500 °C, less than 6% char remains. This sort of thermal behavior is desirable for sacrificial materials.

### Example 25

### Polymerization of NB1 022 and BuNB

Ethyl acetate (5.62g), toluene (16.86g), butyl norbornene (1.82g, 0.0121 mol) and POSS 1022 norbornene (3.795g, 0.004 mol) were added to the reaction vessel. 0.164g (0.34 mmol) of (η⁶-toluene)Ni(C₆F₅)₂ (NiArF) dissolved in 0.62 ml of toluene was injected into the reactor and the reaction mixture stirred at ambient temperature for 6 hours. Peracetic acid (50 molar equivalents based on the nickel catalyst - 17.08 mmol) solution, (7.0g of glacial acetic acid diluted with approximately 10.0 ml deionized water and 14.3g of 30 wt. % hydrogen peroxide) was added and the reaction mixture stirred for an additional 12 hours. Stirring was stopped and after separation, the water layer was removed and 25 mL of distilled water was added to the remaining organic layer. The mixture was stirred for 30 minutes, the layers allowed to separate and after separation the water layer was again removed. This water wash was repeated a total of 3 times. The polymer was then precipitated from the organic layer by addition into 300 mL methanol. The solid polymer was recovered by filtration and dried overnight at 60°C in a vacuum oven. 5.32g of dry polymer (93.2 % conversion) was recovered after drying. Polymer molecular weight Mw = 53,818, Mn = 25,005, polydispersity (PDI) = 2.152. Polymer composition by ¹H NMR: 75 mole % butyl norbornene; 25 mole % POSS 1022 norbornene. A sample of the solid polymer was placed in an AutoTGA 2950HR (Varian) and heated from 25°C to 550°C at a rate of 10°C per minute under an atmosphere of nitrogen gas. At the end of the heating cycle, 99.06% of the original polymer sample weight had been lost.

### Example 26

### Homopolymerization of NB1021

NB1021 (10.0 g, 0.0135 mol) was dissolved in toluene (23 g) and ethylacetate (7.6 g). The monomer solution was sparged with nitrogen. A toluene (2 g) solution of NiArF (0.13 g, 0.27 mmol) was added. The mixture was allowed to stir overnight. After 21 hours, a mixture of glacial acetic acid (4.8 mL) and hydrogen peroxide (30 %, 9 mL) and water (15 mL) was added to the reaction solution. The mixture was stirred. The aqueous layer was removed and the organic phase was washed with water. The organic phase was then poured into methanol. The precipitated polymer was filtered and dried in a vacuum oven at 60 °C overnight. Yield 7.84 g (78%). Mw=39,800 and Mn=19,600. However, ¹H NMR analysis showed that approximately 30% of the product was unreacted monomer.

### Example 27

### Polymerization of MeOAcNB:HEANB:NB1038

The monomers, MeOAcNB (2.19 g, 0.0132 mol), HEANB (8.00 g, 0.0439 mol), NB1038 (29.81 g, 0.0307 mol), triethylsilane (0.316 g, 0.00272 mol), and DANFABA (0.235 g, 0.293 mmol) were dissolved in toluene (69.1 mL) and 1-methoxy-2-propanol (7.7 mL). The reaction mixture was sparged with nitrogen for 30 minutes. [Palladiumbis(tri-i-propylphosphine)(acetonitrile)(acetate)]-[tetrakis(pentafluorophenyl)borate] (0.118 g, 0.0978 mmol) was dissolved in 1,2-dichloroethane and added to the mixture. This mixture was heated to 80 °C and after 18 h the polymerization mixture was cooled. About 20 mL each of Amberlite GT-73 (Rohm and Haas) and Diaion CRBO2 (Mitsubishi Chemical) ion exchange resin were added to the reaction mixture in about 100 mL of THF. The mixture was shaken gently overnight. The mixture was then filtered, ultimately through a 0.2 micron Teflon^{®} filter. The filtrate was concentrated to about 100 mL by rotary evaporation. The solution was poured into heptane to precipitate the polymer. The polymer was allowed to dry at room temperature. It was redissolved in 20 g of toluene and 4 g of THF, heated to 40 °C and poured into 600 mL of heptane. The precipitated polymer was collected and dried at 80 °C in a vacuum oven. Yield 13.7 g (34%). Mw=40800, Mn=15800. The polymer was determined to contain approximately 16 mol% MeOAcNB, 26 mol% NB1038, and 58 mol% HEANB.

### Example 28

### Polymerization of MeOAcNB:HEANB:NB1038

The monomers, MeOAcNB (3.66 g, 0.0220 mol), HEANB (6.42 g, 0.0352 mol), NB1038 (29.91 g, 0.0309 mol), triethylsilane (0.317 g, 0.00273 mol), and DANFABA (0.235 g, 0.293 mmol) were dissolved in toluene (69.3 mL) and 1-methoxy-2-propanol (7.7 mL). The reaction mixture was sparged with nitrogen for 30 minutes. [Palladiumbis(tri-i-propylphosphine)(acetonitrile)(acetate)]-[tetrakis(pentafluorophenyl)borate] (0.118 g, 0.0978 mmol) was dissolved in 1,2-dichloroethane and added to the mixture. This mixture was heated to 80 °C and after 18 h the polymerization mixture was cooled. About 20 mL each of Amberlite GT-73 (Rohm and Haas) and Diaion CRBO2 (Mitsubishi Chemical) ion exchange resin were added to the reaction mixture in about 100 mL of THF. The mixture was shaken gently overnight. The mixture was then filtered, ultimately through a 0.2 micron Teflon^{®} filter. The filtrate was concentrated to about 100 mL using a rotoevaporator. The solution was poured into heptane to precipitate the polymer. The polymer was allowed to dry at room temperature. Yield 13.9 g (35%). Mw=60900, Mn=18800.

### Example 29

### Polymerization of MeOAcNB:HEANB:NB1038

The monomers, MeOAcNB (6.60 g, 0.0397 mol), HEANB (24.0 g, 0.132 mol), NB1038 (89.4 g, 0.0922 mol), and triethylsilane (1.3 mL, 0.0081 mol) were dissolved in toluene (173.2 g) and 1-methoxy-2-propanol (21.3 mL). The reaction mixture was sparged with nitrogen for 15 minutes. This mixture was heated to 80 °C. DANFABA (0.707 g, 0.883 mmol) and [palladiumbis(tri-i-propylphosphine)(acetonitrile)(acetate)][tetrakis(pentafluorophenyl)borate] (0.355 g, 0.294 mmol), dissolved in 1,2-dichloroethane (3 mL each), were added to the mixture. After 18 h, the polymerization mixture was cooled. About 65 mL each of Amberlite GT-73 (Rohm and Haas) and Diaion CRBO2 (Mitsubishi Chemical) ion exchange resin were added to the reaction mixture in about 100 mL of THF. The mixture was shaken gently for about 50 hours. The mixture was then filtered ultimately through a 0.2 micron Teflon^{®} filter. The filtrate was concentrated to about 200 mL using a rotoevaporator. The solution was heated to 50 °C and diluted with about 40 mL of toluene and 10 mL of THF. The solution was poured into an excess of heptane. The precipitated polymer was filtered and dried in a vacuum oven at 85 °C overnight. The polymer was redissolved into toluene and THF and filtered to remove some insolubles. The solution was concentrated to 100 mL by rotary evaporation. The solution was heated to 50 °C and poured into heptane. The precipitated polymer was filtered and dried at 80 °C in a vacuum oven. Yield 48.7 g (41%). Mw=47300, Mn=17100. The polymer was determined to contain approximately 15 mol% MeOAcNB, 26 mol% NB1038, and 59 mol% HEANB.

### Example 30

### Polymerization of MeOAcNB:HEANB:NB1038

The monomers, MeOAcNB (11.2 g, 0.0673 mol), HEANB (40.2 g, 0.221 mol) and NB1038 (149.0 g, 0.154 mol), triethylsilane (1.81 g, 0.0156 mol), DANFABA (1.16 g, 1.45 mmol), and [palladiumbis(tri-i-propylphosphine) (acetonitrile)(acetate)][tetrakis(pentafluorophenyl)-borate] (0.560 g, 0.464 mmol) were dissolved in toluene (273 g) and propylene glycol methylether acetate (32.2 g). The mixture was heated to 80 °C for 18 h. The reaction mixture was cooled and then diluted with THF (180 mL). The mixture was treated with CO (150 psig) at 80 °C for 4 h. The mixture was cooled and filtered through a 1 micron filter, a 0.22 micron filter and then a 0.05 micron filter to remove palladium metal. The reaction mixture then treated with Amberlite GT-73 (Rohm and Haas) and Diaion CRBO2 (Mitsubishi Chemical) ion exchange resin. The reaction mixture was concentrated by rotary evaporation and then poured into heptane. The precipitated polymer was filtered and then dried in a vacuum oven. Yield 83.5 g (45%). Mw=31000, Mn=13700. The polymer was determined to contain approximately 14 mol% MeOAcNB, 27 mol% NB1038, and 59 mol% HEANB.

### EXAMPLE 31

### Polymerization of NB: NB1022

Ethyl acetate (4.03g), toluene (12.4g), norbornene (0.3g, 0.0032 mol) and NB1022 (3.6g, 0.0032 mol) were added to a reaction vessel and the vessel placed in an oil bath and heated to 40°C. 0.062g (0.129 mmol) of NiArf in 0.62 ml of toluene was injected into the reactor and the reaction stirred for 4 hours. Peracetic acid (50 molar equivalents based on the nickel catalyst - 6.46 mmol) solution (2.3g glacial acetic acid diluted with approximately 11.0 ml deionized water and 4.3g of 30 wt. % hydrogen peroxide) was added and the solution was stirred for 12 hours after which the layers were allowed to separate and the organic layer washed as in Example 25. The polymer was then precipitated by addition into 300 mL methanol. The solid polymer was recovered by filtration and dried overnight at 60°C in a vacuum oven. 3.42g of dry polymer (86.1 % conversion) was recovered after drying. Polymer molecular weight: Mw=77,520; Mn=20,341; polydispersity (PDI) = 3.8. Polymer composition by ¹H NMR: 60 mole % norbornene; 40 mole % NB1022.

The polymerizations of Examples 32-41 were performed by the method of Example 31. Therefore only the differences in the specific materials used, amounts and characterization data are noted.

### EXAMPLE 32

### Polymerization of NB: NB1035

Ethyl acetate (3.7g), toluene (11.0g) norbornene (0.3g, 0.0032 mol) and NB1035 (3.37g, 0.0032 mol) were added to the reaction vessel. 0.062g (0.129 mmol) NiArf dissolved in 0.62 ml of toluene was injected into the reactor. 3.84g of dry polymer (99.5 % conversion) was recovered after drying. Polymer molecular weight by Mw = 93,334 Mn = 26,082, polydispersity (PDI) = 3.58. Polymer composition by ¹H NMR: 51 mole % norbornene; 49 mole % NB1035.

### EXAMPLE 33

### Polymerization of NB: NB1038

Ethyl acetate (3.7g), toluene (11.0g), norbornene (0.3g, 0.0032 mol) and NB1038 (3.1g, 0.0032 mol) were added to the reaction vessel. 0.062g (0.129 mmol) NiArf dissolved in 0.62 ml of toluene was injected into the reactor. 2.45g of dry polymer (71.0 % conversion) was recovered after drying. Polymer molecular weight Mw = 101,865 Mn = 33,128, polydispersity (PDI) = 3.06. Polymer composition by ¹H NMR: 63 mole % norbornene; 37 mole % NB1038.

### EXAMPLE 34

### Polymerization of NB: NB1021

Ethyl acetate (4.14g), toluene (12.42g), norbornene (1.14g, 0.012 mol) and NB1021 (3.0g, 0.0040 mol) were added to the reaction vessel. 0.164g (0.34 mmol) of NiArf dissolved in 1.8 ml of toluene was injected into the reactor. 4.14g of dry polymer (99.0 %, conversion) was recovered after drying. Polymer molecular weight Mw = 113,605 Mn = 34,796, polydispersity (PDI) = 3.26. Polymer composition by 1 H NMR: 75 mole % norbornene; 25 mole % NB1021.

### EXAMPLE 35

### Polymerization of BuNB: NB1021

Ethyl acetate (4.82g), toluene (14.46g), butyl norbornene (1.82g, 0.0121 mol) and NB1021 (3.0g, 0.004 mol) were added to the reaction vessel. 0.164g (0.34 mmol) of NiArf dissolved in 0.62 ml of toluene was injected into the reactor. 4.81g of dry polymer (99.4 % conversion) was recovered after drying. Polymer molecular weight Mw=54,677 Mn=18,881, polydispersity (PDI) = 2.90. Polymer composition by ¹H NMR: 75 mole % butyl norbornene; 25 mole % NB1021.

### EXAMPLE 36

### Polymerization of MeOAcNB: NB1021

Ethyl acetate (5.02g), toluene (15.1g), methyl acetate norbornene (2.02g, 0.0121 mol) and NB1021 (3.02g, 0.004 mol) were added to the reaction vessel. 0.164g (0.34mmol) of NiArf dissolved in 0.62 ml of toluene was injected into the reactor. 4.71 g of dry polymer (93.5 % conversion) was recovered after drying. Polymer molecular weight Mw = 38,496 Mn = 17,870, polydispersity (PDI) = 2.15. Polymer composition by ¹H NMR: 75 mole % methyl acetate norbornene; 25 mole % NB1021.

### EXAMPLE 37

### Polymerization of BuNB: NB1021

Ethyl acetate (4.42g), toluene (13.3g), butyl norbornene (1.42g, 0.0096 mol) and NB1021 (3.0g, 0.004 mol) were added to the reaction vessel. 0.13g (0.27 mmol) of NiArf dissolved in 2.2 ml of toluene was injected into the reactor. 4.48g of dry polymer (95.5 % conversion) was recovered after drying. Polymer molecular weight Mw = 64,342 Mn = 21,063, polydispersity (PDI) = 3.05. Polymer composition by ¹H NMR: 70 mole % butyl norbornene; 30 mole % NB1021.

### EXAMPLE 38

### Polymerization of DecylNB: NB1022

Ethyl acetate (3.75g), toluene (11.25g), decyl norbornene (0.75g, 0.0032 mol) and NB1022 (3.0g, 0.0032 mol) were added to the reaction vessel. 0.031g (0.00639 mmol) of NiArf dissolved in 0.62 ml of toluene was injected into the reactor. 2.14g of dry polymer (56.3 % conversion) was recovered after drying. Polymer molecular weight Mw=63,647 Mn=32,521, polydispersity (PDI) = 1.96. Polymer composition by ¹H NMR: 50 mole % decyl norbornene; 50 mole % NB1022.

### EXAMPLE 39

### Polymerization of BuNB: NB1022

Ethyl acetate (3.75g), toluene (11.25g), butyl norbornene (0.0.76g, 0.0032 mol) and NB1022 (3.0g, 0.0032 mol) were added to the reaction vessel. 0.0355g (0.000641 mmol) of NiArf dissolved in 0.62 ml of toluene was injected into the reactor. 2.22g of dry polymer (62.7 % conversion) was recovered after drying. Polymer molecular weight Mw=60,434 Mn=28,652, polydispersity (PDI) = 2.11. Polymer composition by ¹H NMR: 50 mole % butyl norbornene; 50 mole % NB1022.

### EXAMPLE 40

### Polymerization of BuNB: NB1021

Ethyl acetate (4.3g), toluene (12.8g), butyl norbornene (0.27g, 0.0018 mol) and NB1021 (4.0g, 0.0054 mol) were added to the reaction vessel. 0.07g (0.144 mmol) of NiArf dissolved in 2.0 ml of toluene was injected into the reactor. 3.77g of dry polymer (88.3 % conversion) was recovered after drying. Polymer molecular weight Mw = 75,873 Mn = 24,325, polydispersity (PDI) = 3.12. Polymer composition by ¹H NMR: 25 mole % butyl norbornene; 75 mole % NB1021.

### EXAMPLE 41

### Polymerization of BuNB: NB1022

Ethyl acetate (4.3g), toluene (12.8g), butyl norbornene (1.12g, 0.0075 mol) and NB1022 (3.0g, 0.0032 mol) were added to the reaction vessel. 0.135g (0.22 mmol) of NiArf dissolved in 2.0 ml of toluene was injected into the reactor. 3.96g of dry polymer (96.1 % conversion) was recovered after drying. Polymer molecular weight Mw = 102,735 Mn = 23,351, polydispersity (PDI) = 4.4. Polymer composition by ¹H NMR: 70 mole % butyl norbornene; 30 mole % NB1022.

### Example 42

### Dielectric Constant measurement of BuNB/NB1022 polymer

[0099] A nominally 75:25 polymer of butylnorbornene NB1022 (Mw=62,940 and Mn=18,520) was made in a manner similar to that of Example 25. The polymer was then dissolved in mesitylene (15 wt%) and dispensed onto an aluminum wafer (3 inch) which was spun at 600 rpm for 30 seconds and then soft-baked at 100 °C for 5 minutes after which the thickness of the essentially uniform layer of polymer found to be 1.02 microns. Using a mercury contact probe, the capacitance of the film was measured to be 44.30 pF at 10 KHz and 40.48 pF at 100 KHz.

For comparison, a layer of benzocyclobutene polymer was formed on an aluminum wafer (4000 rpm for 60 secs and softbaked at 120 °C for 3 minutes). The capacitance of the resulting 12.5 micron thick film was found to be 3.556 (10 KHz) and 3.410 (100 KHz).

From this capacitance and thickness data, the dielectric constants of the norbornene polymer was calculated and found to be 2.69 and 2.57 at 10 KHz and 100 KHz, respectively. (k=2.65 * [capacitance, NB polymer:BCB] * [thickness, NB polymer: BCB]).

### Optical Density Measurements

The Optical Density (OD) of exemplary polymers is measured by first preparing a 15 weight percent (wt%) solution of the desired polymer in propylene glycol methylether acetate (PGMEA). Solution is then dispensed onto a 1 inch quartz wafer and spun at 500 rpm for 15 sec and 2000 rpm for 60 sec to form a uniform film. The wafer is then baked for 2 min at 130°C. After cooling, the wafer is placed in the optical path of a Cary 400 Scan UV-Vis Spectrophotometer set to a wavelength of 193 nm to determine the absorbance of the film. After the absorbance measurement, a portion of the film is removed to expose the quartz wafer and create a step, and the film thickness (in microns) across that step is measured using a TENCOR Alpha Step 500 Surface Profiler.
OD=absorbance/thickness.

### Etching Rate Measurements.

Etch Rate is measured by preparing a polymer film, as described above, on a 2 inch, HMDS primed silicon wafer. After cooling, the wafer is broken into four pieces. Three of the pieces are placed into the etch chamber of a March, Model CS1701 reactive ion etcher and etched at a pressure of 150 milliTorr and power setting of 200 Watts with CHF3 (flow rate = 10 sccm) and 02 (flow rate = 2.5 sccm). At one minute intervals, the etching is stopped and one of the pieces removed. The thickness of the film on each of the pieces is measured by, first removing a portion of the film to expose the underlying silicon and create a step and then measuring that step using a TENCOR Alpha Step 500 Surface Profiler. A thickness versus etch time plot is generated and the etch rate of the polymer film taken as the slope of the best straight line. This value is then normalized using samples of a film of standard novolac material prepared and etched under identical conditions.

### Imaging Example 1

### Imaging of negative tone polymer

A solution was prepared by dissolving 2.00 g of the polymer obtained from Example 30, 0.10 g hexamethoxymethylmelamine (ICN Biomedicals, 5% wt/wt) as a cross linking agent, 0.06 g Rhordosil (Rhodia Company, 3% wt/wt) as a photoacid generator and 0.04 g of 1 chloro-4-propoxy-9H-thioxanthen-9-one (Aldrich Scientific, 2% wt/wt) as a photosensitizer, in 6.00 g of propylene glycol methyl ether acetate (Sigma-Aldrich, PGMEA).

Bare silicon wafers (Silicon Quest, <1,0,0>) were prepared by passing approximately 0.5 mL of the formulated polymer solution through a 0.2 µm syringe type filter and then onto the wafer. The wafer was spun at 500 rpm for 10 seconds, followed by 2000 rpm for 60 seconds and then soft baked at 130°C for 90 seconds.

Wafers were imaged on an AB-M mask aligner through a test mask using a mercury vapor light source and an I line filter with an exposure dose of 250 mJ. The wafers were post exposure baked at 130 °C for 120 seconds. Latent images were observed following the post exposure bake. The wafers were developed in 1-methoxy-2-propanol acetate (PGMEA) by immersing them in the PGMEA solution for 15 seconds. The wafers were then removed from the solution, rinsed in deionized water and then dried in a stream of dry nitrogen. The previously observed latent images being developed in polymer layer.

In accordance with the statute, the present invention has been described in language more or less specific as to material compositions and uses of such compositions. It is to be understood, however, that the invention is not limited to the specific features shown and described, since the means herein disclosed only encompass exemplary forms of putting the invention into effect. The invention is, therefore, claimed in any of its forms or modifications within the proper scope of the appended claims appropriately interpreted in accordance with the doctrine of equivalents is not limited to the various embodiments and examples depicted herein. Rather such invention incorporates any embodiment of the invention that is a result of the teachings and descriptions herein and that falls within the scope and spirit of such teachings and descriptions.

## Claims

1. An addition polymer comprising;
a first norbornene-type repeating unit derived from a norbornene-type monomers in accordance with Formula A: 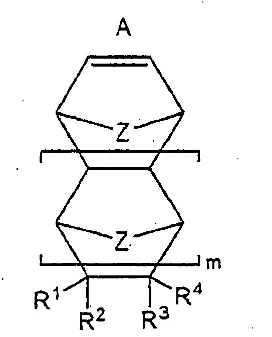 where m is independently an integer from 0 to 5 and Z is, -CH₂-, -(CH₂)₂, - O-, -S-, or -NH-; at least one of R¹, R², R³ and R⁴, independently, is a polyhedral oligosilsesquioxane group and the others of R¹, R², R³ and R⁴ are independently selected from a hydrogen atom, or a linear or branched C₁ to C₂₀ hydrocarbyl group;
a second norbornene-type repeating unit derived from a norbornene-type monomer in accordance with one of Formulae B, C or D: 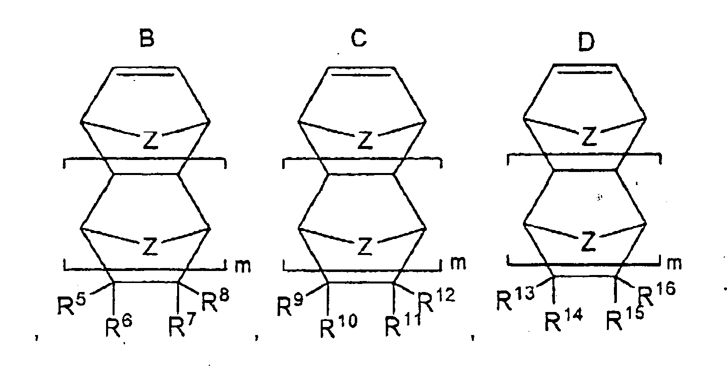 where each m is independently an integer from 0 to 5 and each Z is independently one of -CH₂- -(CH₂)₂, -O-, -S-, or -NH-;
for Formula B, at least one of R⁵, R⁶, R⁷ and R⁸ is a protected acid labile group selected from -((CH₂)ₙO)ₙ-CH₂-C(OR')(CF₃)₂ where n and n* are integers from 0 to about 10, and where R' includes, -CH₂OCH₃, -CH₂OCH₂CH₃. -C(CH₃)₃, -Si(CH₃)₃, -CH₂C(O)O(t-Bu), isobornyl, 2-methyl-2-adamantyl, tetrahydrofuranyl, tetrahydropyranoyl, 3-oxocyclohexanonyl, mevalonic lactonyl, dicyclopropylmethyl, dimethylcyclopropylmethyl, or where R' is -C(O)OR" and R" is -C(CH₃)₃, -Si(CH₃)₃, isobornyl, 2-methyl-2-adamantyl, tetrahydrofuranyl, tetrahydropyranoyl, 3-oxocyclohexanonyl, mevalonic lactonyl, dicyclopropylmethyl, or dimethylcyclopropylmethyl, and the others of R⁵, R⁶, R⁷, or R⁸, independently, can be hydrogen, a C₁ to C₂₀ hydrocarbyl, a halogen, a C₄ to C₁₂ hydrocarbyl substituted at any hydrogen atom with an O, S, N, or Si, or a C₄ to C₁₂ fluorinated hydrocarbyl wherein each carbon atom, independently, is substituted with 0, 1, 2, or 3 fluorine atoms; and
for Formula C, at least one of R⁹, R¹⁰, R¹¹ and R¹² is a crosslinking capable group represented by one of Formulae C1-C5;
where Formula C1 is represented by:
-A-O-[-(CR**₂)_{q}-O-]ₚ-(CR**₂)_{q}-OH
and A is a linking group selected from C₁ to C₆ linear, branched, or C₄-C₆ cyclic alkylene, or -C(O)-, and each occurrence of R** is independently selected from H, methyl, ethyl and a halide, q is independently an integer from 1 to 5, and p is an integer from 0 to 3;
where Formula C2 is represented by:
-R***-Q
and R*** is a linear, branched or cyclic C₁ to C₃₀, optionally partially or completely halogenated, alkylene, arylene, aralkylene, alkarylene, alkenylene or alkynylene linking group and Q is a functional group selected from hydroxyl, carboxylic acid, amine, thiol, isocyanate, an epoxy and a glycidyl ether;
where Formula C3 is represented by:
-CᵣX"₂ᵣ₊₁
and X" is independently a halogen selected from fluorine, chlorine, bromine or iodine and r is an integer from 1 to 20;
where Formula C4 is represented by:
-(CH₂)ₙC(O)OR^{#}
and R# represents an acid labile group cleavable by a photoacid generator as defined above and n is an integer from 1 to 10;
where Formula C5 is represented by:
-(CH₂)ₜ-C(CF₃)ᵣ-O-(CH₂)ₜ-CO-(OR^{##})
and R^{##} is a C₁-C₈ linear or branched alkyl and where each occurrence of t is independently an integer from 1 to 6;
for Formula D, R¹³, R¹⁴, R¹⁵ and R¹⁶, are each independently hydrogen, a linear or branched C₁ to C₁₀ alkyl or a neutral substituent selected from the group of substituents consisting of halogens selected from F, Cl or Br, -(CH₂)ₙ-C(O)OR¹⁷, -(CH₂)ₙ-OR¹⁸, -(CB₂)ₙ-OC(O)R¹⁷, -(CH₂)ₙ-OC(O)OR¹⁷, -(CH₂)ₙ-C(O)R¹⁸, -(CH₂)ₙC(R¹⁹)₂CH(R¹⁹)(C(O)OR²⁰), -(CH₂)ₙC(R¹⁹)₂CH(C(O)OR²⁰)₂, -C(O)O-(CH₂)ₙ-(O-(CH₂)ₙ)ₚ-OR¹⁸ and -(CH₂)ₙ-(O-(CH₂)ₙ)ₚ-OR¹⁸, where n is independently an integer from 0 to 10, p is independently an integer from 0 to 6, B is hydrogen or a halogen, R¹⁹ is independently hydrogen, a halogen, a linear or branched C₁ to C₁₀ alkyl group or C₄ to C₁₂ cycloalkyl group or a linear or branched C₁ to C₁₀ halogenated alkyl group or halogenated C₄ to C₁₂ cycloalkyl group, R¹⁸ is independently hydrogen, a linear or branched C₁ to C₁₀ alkyl group or C₄ to C₁₂ cycloalkyl group or a linear or branched C₁ to C₁₀ halogenated alkyl group or halogenated C₄ to C₁₂ cycloalkyl group, R¹⁷ and R²⁰ are not readily cleavable by a photoacid generator and are, independently, a linear or branched C₁ to C₁₀ alkyl group or halogenated alkyl group, a C₄ to C₁₂ cycloalkyl group or halogenated C₄ to C₁₂ cycloalkyl group, and where R¹⁷, is also a hydrogen, a cyclic ether, a cyclic ketone or a cyclic ester (lactone), where each of the cyclic ether, ketone and ester can be halogenated or not.

2. The polymer of Claim 1, where the second repeating unit is derived from a monomer in accordance with Formula B.

3. The polymer of Claim 1, where the second repeating unit is derived from a monomer in accordance with Formula C.

4. The polymer of Claim 1, where the second repeating unit is derived from a monomer in accordance with Formula D.

5. The polymer of Claim 4, where the monomer in accordance with Formula D is represented by Formula D1:

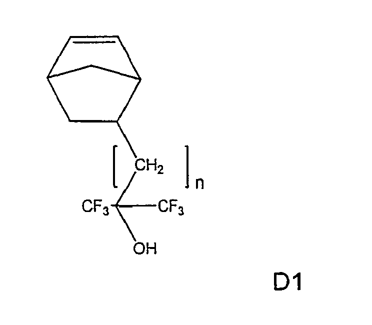

6. The polymer of Claim 2, further comprising a third type of norbornene-type repeating unit derived from a monomer in accordance with Formula C.

7. The polymer of Claim 2, further comprising a third type of norbornene-type repeating unit derived from a monomer in accordance with Formula D.

8. The polymer of Claim 7, where the monomer in accordance with Formula D is represented by Formula D1:

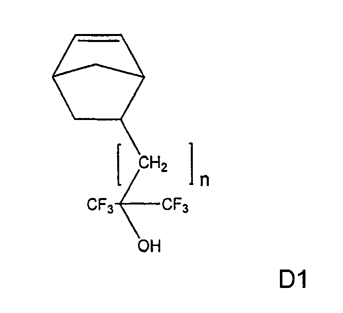

9. The polymer of Claim 6, further comprising a fourth type of norbornene-type repeating unit derived from a monomer in accordance with Formula D.

10. A directly photodefinable polymer composition comprising a polymer in accordance with the polymer of one of Claim 1 through Claim 9, a photoacid generator and/or a photoinitiator.

11. A polymer composition comprising a low dielectric constant polymer in accordance with Claim 1.

12. A micro-electronic device having dielectric structures formed from a polymer in accordance with one of Claim 1 through Claim 9.

13. An etch selective layer comprising a polymer in accordance with the polymer of Claim 1 though Claim 9.

14. A micro-electronic device comprising at least one "air-gap" structure formed at least in part by the gaseous decomposition of a polymer in accordance with the polymers represented by Claim 1 through Claim 9.

15. A sacrificial material comprising a norbornene-type addition polymer having at least a first type of norbornene-type repeating unit and a second type of norbornene-type repeating unit, where said first type consists of a polyhedral oligosilsesquioxane repeat unit.

16. The sacrificial material of Claim 15 where said second type consists of a norbornene-type repeat unit comprising an acid-labile pendant group.

17. The sacrificial material of Claim 15 where said second type consists of a norbornene-type repeat unit comprising a crosslinkable pendant group.

18. A low-K dielectric material comprising a norbornene-type addition polymer having at least a first type of norbornene-type repeating unit and a second type of norbornene-type repeating unit, where said-first type consists of a polyhedral oligosilsesquioxane repeat unit.

19. The low-K dielectric material of Claim 18 where said second type consists of a norbornene-type repeat unit comprising an acid-labile pendant group.

20. The low-K dielectric material of Claim 18 where said second type consists of a norbornene-type repeat unit comprising a crosslinkable pendant group.

## Patentansprüche

1. Additionspolymer, umfassend:
eine erste Repetiereinheit des Norbornentyps, die von einem Monomer des Norbornentyps gemäß Formel A abgeleitet ist: 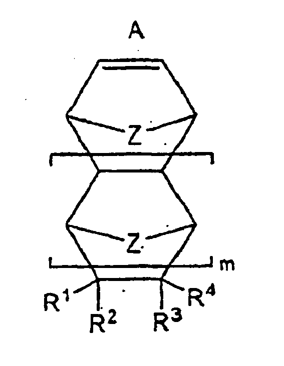 wobei m unabhängig eine ganze Zahl von 0 bis 5 ist und Z = -CH₂-, -(CH₂)₂-, -O-, -S- oder -NH- ist, wenigstens einer der Reste R¹, R², R³ und R⁴ unabhängig eine polyedrische Oligosilsesquioxan-Gruppe ist und die jeweils anderen Reste R¹, R², R³ und R⁴ unabhängig aus einem Wasserstoffatom oder einer linearen oder verzweigten C₁- bis C₂₀-Hydrocarbylgruppe ausgewählt sind;
eine zweite Repetiereinheit des Norbornentyps, die von einem Monomer des Norbornentyps gemäß einer der Formeln B, C oder D abgeleitet ist: 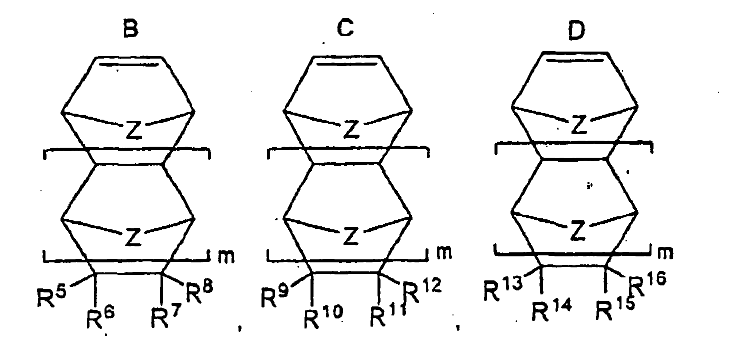
wobei m jeweils unabhängig eine ganze Zahl von 0 bis 5 ist und Z jeweils unabhängig eine der Struktureinheiten -CH₂-, -(CH₂)₂-, -O-, -S- oder -NH- ist;
wobei in Formel B wenigstens einer der Reste R⁵, R⁶, R⁷ und R⁸ eine geschützte säurelabile Gruppe ist, die aus -((CH₂)ₙO)_{n*}-CH₂-C(OR')(CF₃)₂ ausgewählt ist, wobei n und n* ganze Zahlen von 0 bis etwa 10 sind und wobei R' -CH₂OCH₃, -CH₂OCH₂CH₃, -C(CH₃)₃, -Si(CH₃)₃, -CH₂C(O)O(t-Bu), Isobornyl, 2-Methyl-2-adamantyl, Tetrahydrofuranyl, Tetrahydropyranoyl, 3-Oxocyclohexanoyl, Mevalonlactonyl, Dicyclopropylmethyl oder Dimethylcyclopropylmethyl umfasst oder wobei R' = -C(O)OR" ist und R" = -C(CH₃)₃, -Si(CH₃)₃, Isobornyl, 2-Methyl-2-adamantyl, Tetrahydrofuranyl, Tetrahydropyranoyl, 3-Oxocyclohexanoyl, Mevalonlactonyl, Dicyclopropylmethyl oder Dimethylcyclopropylmethyl ist und die jeweils anderen Reste R⁵, R⁶, R⁷ und R⁸ unabhängig Wasserstoff, ein C₁- bis C₂₀-Hydrocarbyl, ein Halogen, ein C₄- bis C₁₂-Hydrocarbyl, das an einem beliebigen Wasserstoffatom mit einem O, S, N oder Si substituiert ist, oder ein fluoriertes C₄- bis C₁₂-Hydrocarbyl, wobei jedes Kohlenstoffatom unabhängig mit 0, 1, 2 oder 3 Fluoratomen substituiert ist, sind; und
wobei in Formel C wenigstens einer der Reste R⁹, R¹⁰, R¹¹ und R¹² eine vernetzungsfähige Gruppe ist, die durch eine der Formeln C1-C5 dargestellt wird;
wobei Formel C1 dargestellt wird durch:
-A-O-[-(CR**₂)_{q}-O-]ₚ-(CR**₂)_{q} -OH
und A eine Verknüpfungsgruppe ist, die aus linearem oder verzweigtem C₁- bis C₆- oder cyclischem C₄- bis C₆-Alkylen oder -C(O)- ausgewählt ist, und R** überall, wo es vorkommt, jeweils unabhängig aus H, Methyl, Ethyl und einem Halogenid ausgewählt ist, q unabhängig eine ganze Zahl von 1 bis 5 ist und p eine ganze Zahl von 0 bis 3 ist;
wobei Formel C2 dargestellt wird durch:
-R***-Q
und R*** eine lineare, verzweigte oder cyclische, gegebenenfalls partiell oder vollständig halogenierte, C₁- bis C₃₀-Alkylen-, -Arylen-, -Aralkylen-, -Alkenylen- oder -Alkinylen-Verknüpfungsgruppe ist und Q eine funktionelle Gruppe ist, die aus Hydroxy, Carbonsäure, Amin, Thiol, Isocyanat, Epoxid und einem Glycidylether ausgewählt ist;
wobei Formel C3 dargestellt wird durch:
-CᵣX"₂ᵣ₊₁
und X" unabhängig ein Halogen ist, das aus Fluor, Chlor, Brom oder Iod ausgewählt ist, und r eine ganze Zahl von 1 bis 20 ist;
wobei Formel C4 dargestellt wird durch:
-(CH₂)ₙC(O)OR^{#}
und R^{#} eine säurelabile Gruppe darstellt, die durch einen Photosäurebildner, wie er oben definiert ist, abspaltbar ist, und n eine ganze Zahl von 1 bis 10 ist;
wobei Formel C5 dargestellt wird durch:
-(CH₂)ₜ-C(CF₃)₂-O-(CH₂)ₜ-CO-(OR^{##})
und R^{##} ein lineares oder verzweigtes C₁-C₈-Alkyl ist und wobei t überall, wo es vorkommt, jeweils unabhängig eine ganze Zahl von 1 bis 6 ist;
wobei in Formel D R¹³, R¹⁴, R¹⁵ und R¹⁶ jeweils unabhängig Wasserstoff, ein lineares oder verzweigtes C₁-C₁₀-Alkyl oder ein neutraler Substituent, der aus der Gruppe von Substituenten ausgewählt ist, die aus Halogenen, die aus F, Cl oder Br ausgewählt sind, -(CH₂)ₙ-C(O)OR¹⁷, -(CH₂)ₙ,-OR¹⁸, -(CB₂)ₙ-OC(O)R¹⁷, -(CH₂)ₙ-OC(O)OR¹⁷, -(CH₂)ₙ-C(O)R¹⁸, -(CH₂)ₙC(R¹⁹)₂CH(R¹⁹)(C(O)OR²⁰), -(CH₂)ₙC(R¹⁹)₂CH(C(O)OR²⁰)₂, -C(O)O-(CH₂)ₙ-(O-(CH₂)ₙ)ₚ-OR¹⁸ und -(CH₂)ₙ-(O-(CH₂)ₙ)ₚ-OR¹⁸ besteht, sind, wobei n unabhängig eine ganze Zahl von 0 bis 10 ist, p unabhängig eine ganze Zahl von 0 bis 6 ist, B Wasserstoff oder ein Halogen ist, R¹⁹ unabhängig Wasserstoff, ein Halogen, eine lineare oder verzweigte C₁- bis C₁₀-Alkylgruppe oder C₄- bis C₁₂-Cycloalkylgruppe oder eine lineare oder verzweigte halogenierte C₁- bis C₁₀-Alkylgruppe oder halogenierte C₄- bis C₁₂-Cycloalkylgruppe ist, R¹⁸ unabhängig Wasserstoff, eine lineare oder verzweigte C₁- bis C₁₀-Alkylgruppe oder C₄- bis C₁₂-Cycloalkylgruppe oder eine lineare oder verzweigte halogenierte C₁- bis C₁₀-Alkylgruppe oder halogenierte C₄- bis C₁₂-Cycloalkylgruppe ist, R¹⁷ und R²⁰ durch einen Photosäurebildner nicht leicht abspaltbar sind und unabhängig eine lineare oder verzweigte C₁- bis C₁₀-Alkylgruppe oder halogenierte Alkylgruppe, eine C₄- bis C₁₂-Cycloalkylgruppe oder halogenierte C₄- bis C₁₂-Cycloalkylgruppe sind und wobei R¹⁷ auch ein Wasserstoff, cyclischer Ether, cyclisches Keton oder cyclischer Ester (Lacton) sein kann, wobei der cyclische Ether, das cyclische Keton und der cyclische Ester jeweils halogeniert sein können oder auch nicht.

2. Polymer gemäß Anspruch 1, wobei die zweite Repetiereinheit von einem Monomer gemäß Formel B abgeleitet ist.

3. Polymer gemäß Anspruch 1, wobei die zweite Repetiereinheit von einem Monomer gemäß Formel C abgeleitet ist.

4. Polymer gemäß Anspruch 1, wobei die zweite Repetiereinheit von einem Monomer gemäß Formel D abgeleitet ist.

5. Polymer gemäß Anspruch 4, wobei das Monomer gemäß Formel D durch Formel D1 dargestellt wird:

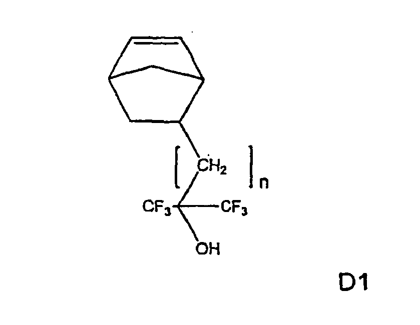

6. Polymer gemäß Anspruch 2, das weiterhin einen dritten Typ von Repetiereinheit des Norbornentyps umfasst, der von einem Monomer gemäß Formel C abgeleitet ist.

7. Polymer gemäß Anspruch 2, das weiterhin einen dritten Typ von Repetiereinheit des Norbornentyps umfasst, der von einem Monomer gemäß Formel D abgeleitet ist.

8. Polymer gemäß Anspruch 7, wobei das Monomer gemäß Formel D durch Formel D1 dargestellt wird:

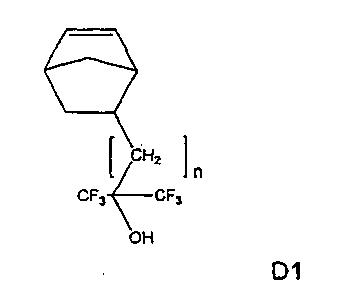

9. Polymer gemäß Anspruch 6, das weiterhin einen vierten Typ von Repetiereinheit des Norbornentyps umfasst, der von einem Monomer gemäß Formel D abgeleitet ist.

10. Direkt photostrukturierbare Polymerzusammensetzung, die ein Polymer gemäß einem der Ansprüche 1 bis 9, einen Photosäurebildner und/oder einen Photoinitiator umfasst.

11. Polymerzusammensetzung, die ein Polymer mit niedriger Dielektrizitätskonstante gemäß Anspruch 1 umfasst.

12. Mikroelektronische Vorrichtung mit dielektrischen Strukturen, die aus einem Polymer gemäß einem der Ansprüche 1 bis 9 gebildet sind.

13. Ätzselektive Schicht, die ein Polymer gemäß einem der Ansprüche 1 bis 9 umfasst.

14. Mikroelektronische Vorrichtung, die wenigstens eine "Luftspaltstruktur" umfasst, welche wenigstens zum Teil durch die in der Gasphase erfolgende Zersetzung eines Polymers gemäß einem der Ansprüche 1 bis 9 gebildet ist.

15. Opfermaterial, das ein Additionspolymer des Norbornentyps umfasst, welches wenigstens einen ersten Typ von Repetiereinheit des Norbornentyps und einen zweiten Typ von Repetiereinheit des Norbornentyps aufweist, wobei der erste Typ aus einer polyedrischen Oligosilsesquioxan-Repetiereinheit besteht.

16. Opfermaterial gemäß Anspruch 15, wobei der zweite Typ aus einer Repetiereinheit des Norbornentyps besteht, die eine säurelabile seitenständige Gruppe umfasst.

17. Opfermaterial gemäß Anspruch 15, wobei der zweite Typ aus einer Repetiereinheit des Norbornentyps besteht, die eine vernetzbare seitenständige Gruppe umfasst.

18. Low-K-Dielektrikum, das ein Additionspolymer des Norbornentyps umfasst, welches wenigstens einen ersten Typ von Repetiereinheit des Norbornentyps und einen zweiten Typ von Repetiereinheit des Norbornentyps aufweist, wobei der erste Typ aus einer polyedrischen Oligosilsesquioxan-Repetiereinheit besteht.

19. Low-K-Dielektrikum gemäß Anspruch 18, wobei der zweite Typ aus einer Repetiereinheit des Norbornentyps besteht, die eine säurelabile seitenständige Gruppe umfasst.

20. Low-K-Dielektrikum gemäß Anspruch 18, wobei der zweite Typ aus einer Repetiereinheit des Norbornentyps besteht, die eine vernetzbare seitenständige Gruppe umfasst.

## Revendications

1. Polymère d'addition, comprenant:
un premier motif de répétition de type norbornène dérivé d'un monomère de type norbornène selon la formule A: 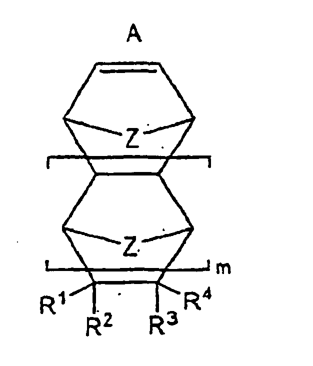 où m est indépendamment un nombre entier de 0 à 5, et Z représente -CH₂-, -(CH₂)₂-, -O-, -S- ou -NH-, au moins un de R¹, R², R³ et R⁴ est indépendamment un groupe oligosilsesquioxanne polyédrique et les autres R¹, R², R³ et R⁴ sont indépendamment choisis parmi un atome d'hydrogène ou un groupe hydrocarbyle en C₁ à C₂₀ linéaire ou ramifié;
un second motif de répétition de type norbornène dérivé d'un monomère de type norbornène selon l'une des formules B, C ou D: 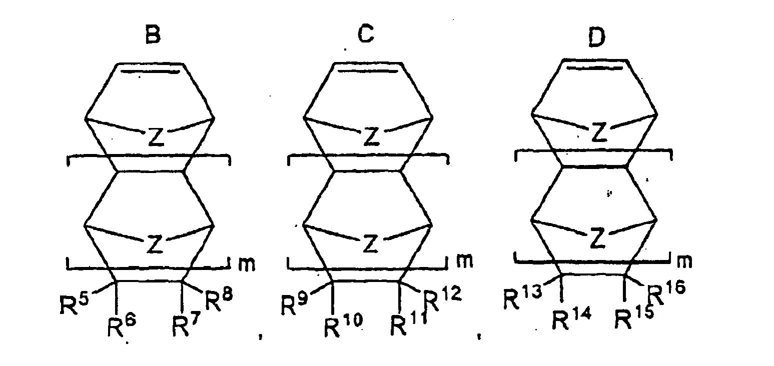
où chaque m est indépendamment un nombre entier de 0 à 5, et chaque Z est indépendamment un de -CH₂-, -(CH₂)₂-, -O-, -S- ou -NH-;
pour la formule B, au moins un de R⁵, R⁶, R⁷ et R⁸ est un groupe labile aux acides protégé choisi parmi -((CH₂)ₙO)_{n*}-CH₂-C(OR')(CF₃)₂, dans lequel n et n* sont des nombres entiers de 0 à 10 environ, et dans lequel R' comprend -CH₂OCH₃, -CH₂OCH₂CH₃, -C(CH₃)₃, -Si(CH₃)₃, -CH₂C(O)O(t-Bu), isobornyle, 2-méthyl-2-adamantyle, tétrahydrofuranyle, tétrahydropyranoyle, 3-oxocyclohexanoyle, mévalonolactonyle, dicyclopropylméthyle ou diméthylcyclopropylméthyle, ou dans lequel R' est -C(O)OR" et R" est -C(CH₃)₃, -Si(CH₃)₃, isobornyle, 2-méthyl-2-adamantyle, tétrahydrofuranyle, tétrahydropyranoyle, 3-oxocyclohexanoyle, mévalonolactonyle, dicyclopropylméthyle ou diméthylcyclopropylméthyle, et les autres R⁵, R⁶, R⁷ et R⁸ sont indépendamment l'hydrogène, un groupe hydrocarbyle en C₁ à C₂₀, un halogène, un groupe hydrocarbyle en C₁ à C₂₀ substitué à un atome d'hydrogène quelconque avec un O, S, N ou Si, ou un groupe hydrocarbyle en C₄ à C₁₂ fluoré, dans lequel chaque atome de carbone est indépendamment substitué avec 0, 1, 2 ou 3 atomes de fluor; et
pour la formule C, au moins un de R⁹, R¹⁰, R¹¹ et R¹² est un groupe capable de réticulation représenté par l'une des formules C1 à C5;
où la formule C1 est représentée par:
-A-O- [-(CR**₂)_{q}-O-]ₚ-(CR**₂)_{q}-OH
et A est un groupe de liaison choisi parmi les groupes alkylène en C₁ à C₆ linéaires ou ramifiés ou en C₄ à C₆ cycliques ou -C(O)-, et chaque occurrence de R** est indépendamment choisie parmi H, méthyle, éthyle et un halogénure, q est indépendamment un nombre entier de 1 à 5, et p est un nombre entier de 0 à 3;
où la formule C2 est représentée par:
-R***-Q
et R*** est un groupement de liaison alkylène, arylène, aralkylène, alkarylène, alkénylène ou alkynylène en C₁ à C₃₀ linéaire, ramifié ou cyclique, éventuellement halogéné partiellement ou complètement, et Q est un groupe fonctionnel choisi parmi un groupe hydroxyle, acide carboxylique, amine, thiol, isocyanate, époxyde et glycidyle éther;
où la formule C3 est représentée par:
-CᵣX^{"}₂ᵣ₊₁
et X" est indépendamment un halogène choisi parmi le fluor, le chlore, le brome ou l'iode, et r est un nombre entier de 1 à 20;
où la formule C4 est représentée par:
-(CH₂)ₙC(O)OR^{#}
et R^{#} représente un groupe labile aux acides dissociable par un générateur photoacide comme défini plus haut, et n est un nombre entier de 1 à 10;
où la formule C5 est représentée par:
-(CH₂)ₜ-C(CF₃)₂-O-(CH₃)ₜ-CO-(OR^{##})
et R^{##} est un groupe alkyle en C₁ à C₈ linéaire ou ramifié, et où chaque occurrence de t est indépendamment un nombre entier de 1 à 6;
pour la formule D, R¹³, R¹⁴, R¹⁵ et R¹⁶ sont chacun indépendamment l'hydrogène, un groupe alkyle en C₁ à C₁₀ linéaire ou ramifié, ou un substituent neutre choisi dans le groupe de substituants consistant en halogènes choisis parmi F, Cl ou Br, -(CH₂)ₙ-C(O)OR¹⁷, -(CH₂)ₙ-OR¹⁸, -(CB₂)ₙ-OC(O)R¹⁷, -(CH₂)ₙ-OC(O)OR¹⁷, -(CH₂)ₙ-C(O)R¹⁸, -(CH₂)ₙC(R¹⁹)₂-_{CH}(R¹⁹)(C(O)OR²⁰), -(CH₂)ₙC(R¹⁹)₂CH(C(O)OR²⁰)₂, -C(O)O-(CH₂)ₙ-(O-(CH₂)ₙ)ₚ-OR¹⁸ et -(CH₂)ₙ-(O-(CH₂)ₙ)ₚ-OR¹⁸, dans lequel n est indépendamment un nombre entier de 0 à 10, p est indépendamment un nombre entier de 0 à 6, B est l'hydrogène ou un halogène, R¹⁹ est indépendamment l'hydrogène, un halogène, un groupe alkyle en C₁ à C₁₀ ou cycloalkyle en C₄ à C₁₂ linéaire ou ramifié ou un groupe alkyle halogéné en C₁ à C₁₀ linéaire ou ramifié ou un groupe cycloalkyle halogéné en C₄ à C₁₂, R¹⁸ est indépendamment l'hydrogène, un groupe alkyle en C₁ à C₁₀ ou cycloalkyle en C₄ à C₁₂ linéaire ou ramifié ou un groupe alkyle halogéné en C₁ à C₁₀ linéaire ou ramifié ou un groupe cycloalkyle halogéné en C₄ à C₁₂, R¹⁷ et R²⁰ ne sont pas facilement dissociable par un générateur photoacide et sont indépendamment un groupe alkyle en C₁ à C₁₀ ou un groupe alkyle halogéné linéaire ou ramifié, un groupe cycloalkyle en C₄ à C₁₂ ou un groupe cycloalkyle halogéné en C₄ à C₁₂, et dans lequel R¹⁷ peut aussi représenter l'hydrogène, un éther cyclique, une cétone cyclique ou un ester cyclique (lactone) dans lequel chacun des éther, cétone et ester cycliques peut être halogéné ou non.

2. Polymère selon la revendication 1, dans lequel le second motif de répétition est dérivé d'un monomère selon la formule B.

3. Polymère selon la revendication 1, dans lequel le second motif de répétition est dérivé d'un monomère selon la formule C.

4. Polymère selon la revendication 1, dans lequel le second motif de répétition est dérivé d'un monomère selon la formule D.

5. Polymère selon la revendication 4, dans lequel le monomère selon la formule D est représenté par la formule D1:

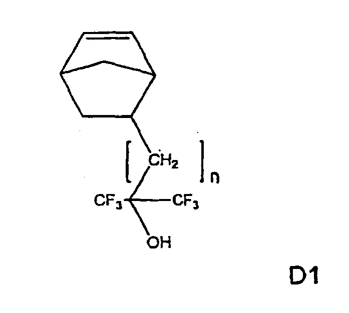

6. Polymère selon la revendication 2, comprenant en outre un troisième type de motif de répétition de type norbornène dérivé d'un monomère selon la formule C.

7. Polymère selon la revendication 2, comprenant en outre un troisième type de motif de répétition de type norbornène dérivé d'un monomère selon la formule D.

8. Polymère selon la revendication 7, dans lequel le monomère selon la formule D est représenté par la formule D1:

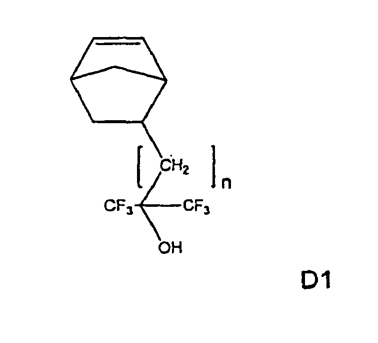

9. Polymère selon la revendication 6, comprenant en outre un quatrième type de motif de répétition de type norbornène dérivé d'un monomère selon la formule D.

10. Composition de polymère directement photodéfinissable comprenant un polymère selon l'une des revendications 1 à 9, un générateur photoacide et/ou une photo-amorce.

11. Composition de polymère comprenant un polymère à basse constante diélectrique selon la revendication 1.

12. Dispositif microélectronique ayant des structures diélectriques formées à partir d'un polymère selon l'une des revendications 1 à 9.

13. Couche sélective relativement à l'attaque chimique, comprenant un polymère selon l'une des revendications 1 à 9.

14. Dispositif microélectronique comprenant au moins une structure "intervalle d'air" formée au moins partiellement par la décomposition en phase gazeuse d'un polymère selon l'une des revendications 1 à 9.

15. Matériau sacrificiel comprenant un polymère d'addition de type norbornène ayant au moins un premier type de motif de répétition de type norbornène et un second type de motif de répétition de type norbornène, dans lequel ledit premier type consiste en un motif de répétition oligosilsesquioxanne polyédrique.

16. Matériau sacrificiel selon la revendication 15, dans lequel ledit second type consiste en un motif de répétition comprenant un groupe pendant labile aux acides.

17. Matériau sacrificiel selon la revendication 15, dans lequel ledit second type consiste en un motif de répétition comprenant un groupe pendant capable de réticulation.

18. Matériau diélectrique à faible coefficient K comprenant un polymère d'addition de type norbornène ayant au moins un premier type de motif de répétition de type norbornène et un second type de motif de répétition de type norbornène, dans lequel ledit premier type consiste en un motif de répétition oligosilsesquioxanne polyédrique.

19. Matériau diélectrique à faible coefficient K selon la revendication 18, dans lequel ledit second type consiste en un motif de répétition comprenant un groupe pendant labile aux acides.

20. Matériau diélectrique à faible coefficient K selon la revendication 18, dans lequel ledit second type consiste en un motif de répétition comprenant un groupe pendant capable de réticulation.
